# EUROPEAN PATENT APPLICATION

(11) **EP 4 664 510 A1**
(43) Date of publication of application: **17.12.2025**
(21) Application number: 25179230.5
(22) Date of filing: 27.05.2025
(51) Int. Cl.: H01L 21/768, H01L 23/485, H01L 23/532, H01L 21/285, H10D 30/00

(54) **SELECTIVE CONDUCTIVE CAP AND LINER DEPOSITION TECHNIQUES FOR INTERCONNECTS AND CONTACT STRUCTURES**

(30) Priority: 06.06.2024 US 202418735768
(71) Applicant: INTEL Corporation, Santa Clara, CA 95054 (US)
(72) Inventor: JEZEWSKI, Christopher J., Portland, 97229 (US); KALITA, Abinasha, Portland, 97229 (US); BONDOC, Ariana E., Hillsboro, 97123 (US); CHEN, Jiun-Ruey, Hillsboro, 97124 (US); SEMPRONI, Scott, Fair Lawn, 07410 (US); BISWAS, Indrani, Hillsboro, 97124 (US); BORLA, Collin, Sherwood, 97140 (US); METZ, Matthew V., Portland, 97229 (US); CHOWDHURY, Akm Shaestagir, Portland, 97229 (US)
(74) Representative: 2SPL Patentanwälte PartG mbB

(57) **Abstract**

Selective metal capping and/or liner materials and processes described herein may enable hermetically encapsulating metal interconnects and metal-silicon interfaces in transistor contacts. In one example, an IC structure includes an interconnect layer with a conductive interconnect that is lined with a ruthenium-based liner, and capped with a selectively deposited cap that includes one or more of ruthenium, molybdenum, tungsten, rhodium, iridium, rhenium, and niobium individually or in an alloy. In another example, an IC structure includes a transistor contact structure with a selectively deposited conductive cap over an interface material, where the conductive cap material is absent or substantially thinner on sidewalls of the contact opening. In one example, the conductive cap material over the Si-metal interface includes one or more of ruthenium, molybdenum, tungsten, rhodium, iridium, platinum, rhenium, cobalt, and niobium individually or in combination.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component is becoming increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a cross-sectional side view of an example IC structure that may be fabricated with selective cap and liner deposition techniques, in accordance with some embodiments.
FIGS. 2A-2B illustrate cross-sectional side views of an example IC structure with conductive lines IC structures fabricated using selective cap and liner deposition techniques.
FIG. 3 provides a perspective view of an example nanoribbon field-effect transistor (FET), according to one embodiment of the present disclosure.
FIGS. 4A-4B illustrate cross-sectional side views of an example IC structure with contact structures IC structures fabricated using selective cap and liner deposition techniques, in accordance with embodiments disclosed herein.
FIGS. 5A-5B illustrate cross-sectional side views of another example IC structure with contact structures IC structures fabricated using selective cap and liner deposition techniques, in accordance with embodiments disclosed herein.
FIGS. 6A-6B illustrate cross-sectional side views of another example IC structure with contact structures IC structures fabricated using selective cap and liner deposition techniques, in accordance with embodiments disclosed herein.
FIG. 7 is a flow diagram of an example method for fabricating an IC structure using selective cap and liner deposition techniques, in accordance with some embodiments.
FIGS. 8-13 are cross-sectional side views at various stages in the fabrication of an example IC structure according to the method of FIG. 7, in accordance with some embodiments.
FIG. 14 is a flow diagram of an example method for fabricating an IC structure using selective cap and liner deposition techniques, in accordance with some embodiments.
FIGS. 15-16, 17A-17B, 18A-18D, and 19A-19D are cross-sectional side views at various stages in the fabrication of an example IC structure according to the method of FIG. 14, in accordance with some embodiments.
FIGS. 20A-20B illustrate cross-sectional side views of example IC structures with contact structures IC structures fabricated using selective cap and liner deposition techniques, in accordance with embodiments disclosed herein.
FIG. 21 is a top view of a wafer and dies that may include any of the IC devices disclosed herein, in accordance with any of the embodiments disclosed herein.
FIG. 22 is a side, cross-sectional view of an IC package that may include any of the IC devices disclosed herein, in accordance with various embodiments.
FIG. 23 is a side, cross-sectional view of an IC device assembly that may include any of the IC devices disclosed herein, in accordance with any of the embodiments disclosed herein.
FIG. 24 is a block diagram of an example electrical device that may include any of the IC devices disclosed herein, in accordance with any of the embodiments disclosed herein.

### Detailed Description

Disclosed herein are IC structures and devices fabricated with selective cap and liner deposition techniques. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

As IC structures become more compact with smaller feature sizes and higher device density, new challenges arise in the fabrication processes of such devices. For example, as the width and pitch of metal interconnects decrease, the area available for the conductive fill material (e.g., copper) decreases, which can increase resistance and negatively impact performance. Thus, the metallization of metal interconnects with tight pitches that meet resistivity targets can be challenging. As the interconnect width scales, scaling the liner portions (e.g., barrier and/or adhesion layers) of the metal interconnects can enable the metal area to be maximized to provide low resistance. Technologies utilizing new liner materials have emerged to enable ultra-thin liners, thus enabling further reductions in metal interconnect widths. However, existing capping materials and techniques may be lacking when combined with the novel liner materials. For example, depositing a cobalt cap over a metal interconnect lined with a novel liner material may require depositing an excessively thick layer of cobalt over the metal line, which can negatively impact device performance (e.g., by reducing shorting margin in the interconnects and increasing capacitance and RC delay).

Another challenge arising from shrinking device size is the reduction of contact resistance (e.g., the resistance of metal-to-silicon in a transistor contact structure) as the dimensions of the transistor contact area decreases while also maintaining compatibility with the materials used in the metallization of the transistor contacts. Contact metallic materials (e.g., the interface material between the silicon and contact fill material, such as a metal silicide) may be susceptible to oxidation and attack from metallization deposition byproducts. A capping material may be used to protect the interface material, but a cap in the contact structure may take up excessive space, which may limit scaling and increase resistance.

In contrast, examples described herein use a novel selective metal capping and/or liner materials and processes to enable hermetically encapsulating metal interconnects and metal-silicon interfaces in transistor contacts (e.g., against subsequent in-situ deposition chemistries or ex-situ ambient exposure and oxidation). In one example, an IC structure includes an interconnect layer with a conductive interconnect that is lined with a ruthenium-based liner, and capped with a selectively deposited cap that includes one or more of ruthenium, molybdenum, tungsten, rhodium, iridium, rhenium, and niobium individually or in an alloy (e.g., with cobalt or other materials). In another example, an IC structure includes a transistor contact structure (e.g., a source or drain contact structure) with a selectively deposited conductive cap over an interface material (e.g., a silicide), where the conductive cap material is absent or substantially thinner on sidewalls of the contact opening. In one example, the conductive cap material over the Si-metal interface includes one or more of ruthenium, molybdenum, tungsten, rhodium, iridium, platinum, rhenium, cobalt, and niobium individually or in combination (e.g., as a multi-layer or as an alloy). In accordance with examples described herein, the selectively deposited caps and/or liners may enable reduced resistance conductive interconnects and contact structures and improved reliability without occupying excessive area.

IC structures as described herein, in particular IC structures selective cap and liner deposition techniques, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

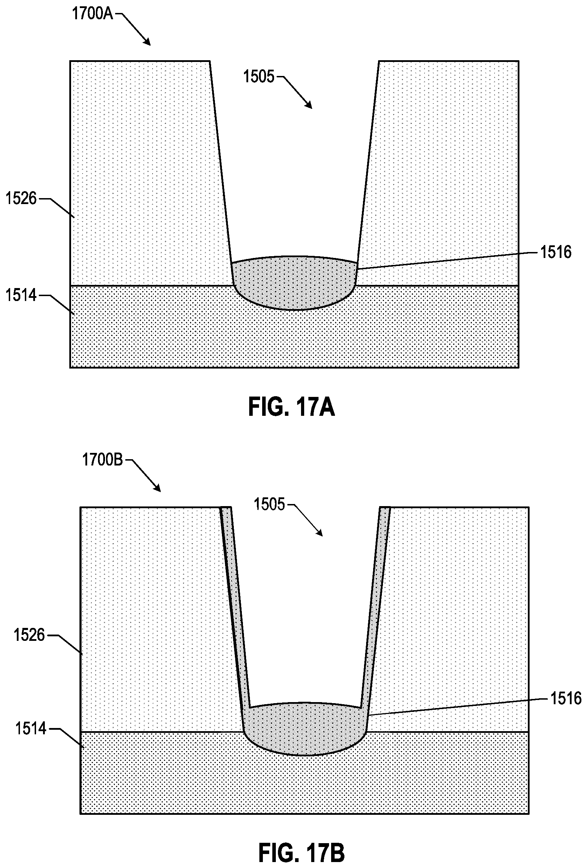

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 17A-17B, such a collection may be referred to herein without the letters, e.g., as "FIG. 17."

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures fabricated using selective cap and liner deposition techniques as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

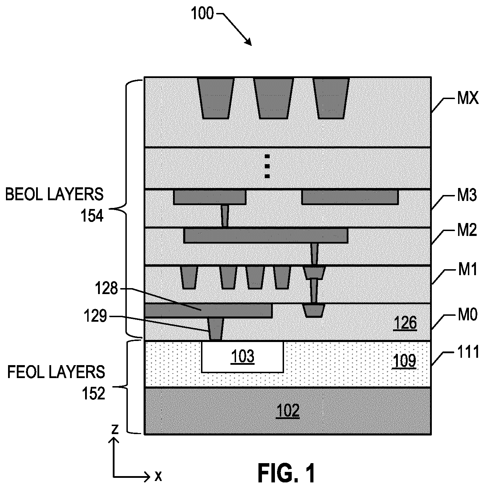

FIG. 1 is a cross-sectional side view of an example IC structure 100 that may be fabricated with selective cap and liner deposition techniques, in accordance with some embodiments.

The IC structure 100 includes front end of line (FEOL) layers 152 and back end of line (BEOL) layers 154. The FEOL and BEOL refer to different stages in IC fabrication. The first stage is referred to as the FEOL. The second stage is referred to as the BEOL. In the FEOL, individual semiconductor devices components (e.g., transistor, capacitors, resistors, etc.) can be patterned in a wafer. In the BEOL, interconnect structures such as conductive lines and conductive vias, separated as needed by an insulator material, can be formed to get the individual components interconnected.

The FEOL layers 152 include a device region 111 over a substrate 102. The substrate 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. The substrate may be, include, or be a part of a support or support structure over which the FEOL layers 152 and the BEOL layers 154 are disposed.

The device region 111 may include a plurality of layers and may include frontend devices, such as the device 103. The device region 111 may include one or more materials 109 between devices, including one or more of an insulator material, a semiconductor material, and/or a conductive material. The device 103 may include, for example, a frontend transistor, a memory cell, or other frontend device. The device 103 may be a transistor of any architecture, such as any non-planar or planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field.

The BEOL layers 154 may include a plurality of backend interconnects electrically coupled to (e.g., in electrically conductive contact with at least portions of) one or more of the plurality of FEOL devices (e.g., the device 103) of the FEOL layers 152. Various BEOL interconnect layers 154 may be/include one or more metal layers of a metallization stack of the IC device. Various metal layers of the BEOL interconnect layers 154 may be used to interconnect the various inputs and outputs of the devices (e.g., logic devices) in the FEOL layer 152. The BEOL layers 154 in FIG. 1 are labeled with an M followed by a number indicating the layer in the metallization stack (e.g., metal layer 0 is M0, metal layer 1 is M1, etc.). In the example in FIG. 1, the metallization stack is depicted as having N+1 metal layers (layers M0-MN), where N is a positive integer greater than or equal to 4. However, the metallization stack may include fewer or more metal layers then depicted in FIG. 1. In one example, each of the BEOL interconnect layers 154 may include vias and lines/trenches. For example, the BEOL interconnect layer M0 includes a via portion 129 and a line or trench/interconnect portion 128. The trench portion 128 of a metal layer is configured for transferring signals and power along electrically conductive (e.g., metal) lines (also sometimes referred to as "trenches") extending in the x-y plane (e.g., in the x or y directions), while the via portion 129 of a metal layer is configured for transferring signals and power through electrically conductive vias extending in the z-direction, e.g., to any of the adjacent metal layers above or below. Accordingly, in one example, vias connect metal structures (e.g., metal lines or vias) from one metal layer to metal structures of an adjacent metal layer. While referred to as "metal" layers, various layers of the BEOL interconnect layers 154 may include only certain patterns of conductive metals, e.g., copper (Cu), aluminum (Al), tungsten (W), or cobalt (Co), or metal alloys, or more generally, patterns of an electrically conductive material, formed in an insulating medium such as an interlayer dielectric (ILD) 126. The insulating medium may include any suitable ILD materials such as silicon oxide, carbon-doped silicon oxide, silicon carbide, silicon nitride, aluminum oxide, and/or silicon oxynitride. In some embodiments, the dielectric material 126 disposed between the interconnect structures in different ones of the interconnect layers may have different compositions; in other embodiments, the composition of the dielectric material 126 between different interconnect layers may be the same.

In accordance with examples described herein, selective deposition techniques may be used to form liners and/or conductive caps for conductive structures in the FEOL layers 152 and/or the BEOL layers 154. For example, selective deposition techniques may be used to form metal lines in one or more BEOL layers 154 that have a liner and cap to encapsulate the metal lines with novel liner and cap materials. For example, novel liner materials may include a conductive material that includes ruthenium. For example, a liner for metal lines may include tantalum, nitrogen, and ruthenium (e.g., TaNRu, RuTaN, or TaNRuTaN) or tantalum, nitrogen, ruthenium, and cobalt (e.g., TaNRuTaNCo). In another example, the liner may include a multi-layered liner that includes one layer or liner of one conductive material (e.g., tantalum nitride (TaN)) and another layer or liner of another conductive material that includes ruthenium (e.g., a material that includes ruthenium and cobalt (RuCo)).

In one example, the liner and cap for metal lines may have different material compositions but include materials that do not exhibit solid solubility (e.g., one material does not migrate into the other, or there is minimal migration of one material into the other). For example, the cap material and the liner material may both include ruthenium. In another example, the liner material includes ruthenium, and the cap material incudes another compatible conductive material, such as molybdenum, tungsten, rhodium, iridium, rhenium, and niobium, individually or in combination as alloys. In one such example, metal lines are capped with an alloy including cobalt and one or more of ruthenium, molybdenum, tungsten, rhodium, iridium, rhenium, and niobium. In one example, the conductive cap together with the liner encapsulate the metal lines to reduce electromigration and improve device reliability. According to examples, the selective cap and liner deposition techniques may be used to line and cap metal interconnects in any metal layer, and may be especially beneficial in lower metal layers with tighter pitches and smaller widths (e.g., M0, M1, M2, etc.).

Selective deposition of novel cap materials may also be used to form conductive contact structures for transistors in the FEOL layers 152. For example, a contact structure coupled with a source region or a drain region ("an S/D region") of a transistor may include a selectively deposited conductive cap between the semiconductor material and the conductive fill material of the contact structure. For example, a conductive cap may be selectively deposited over an interface material (e.g., over a silicide formed on the doped semiconductor material of the S/D region) with no or minimal deposition on sidewalls of the contact opening to form a selective cap over the interface material without narrowing the contact opening. In one such example, a novel cap material in a S/D contact structure may include one or more of ruthenium, molybdenum, tungsten, rhodium, iridium, platinum, rhenium, cobalt, and niobium either individually or in combination as a multi-layer or in combination as an alloy. In one such example, the selectively deposited cap over the interface material in the contact structure opening may protect the interface material from the subsequent metallization process without taking up space on the sidewalls of the contact opening.

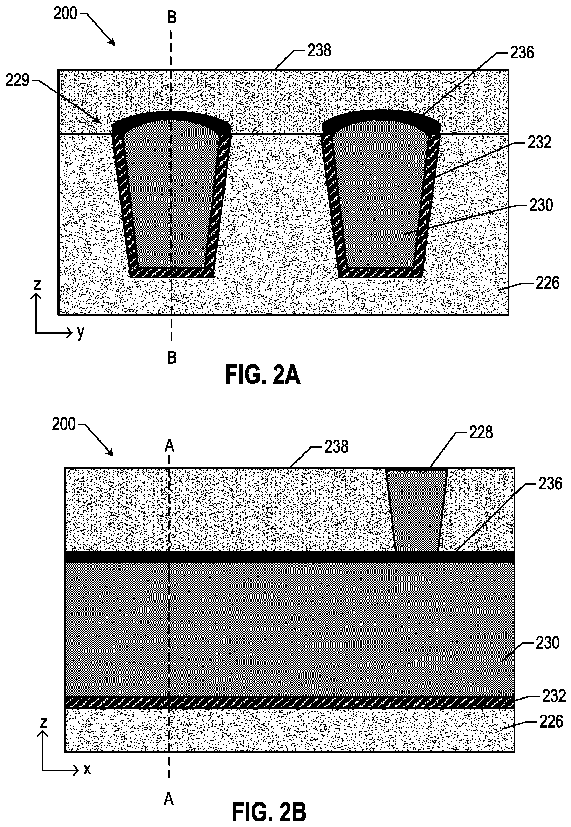

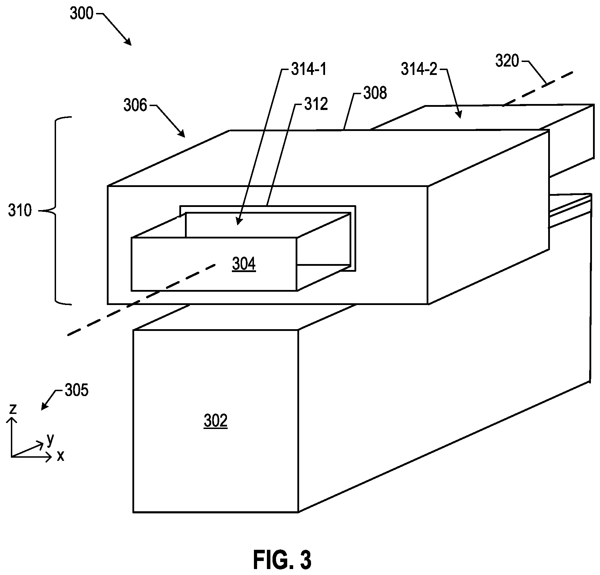

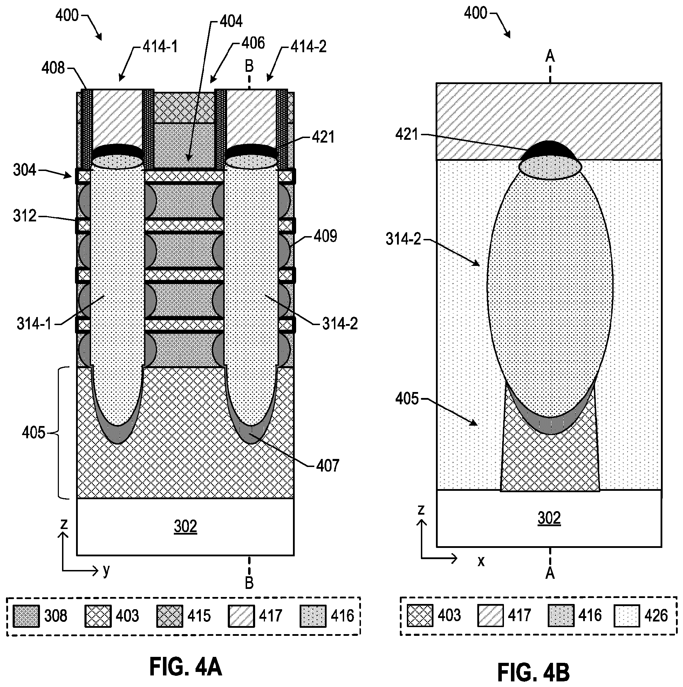

FIGS. 2A-2B illustrate cross-sectional side views of an IC structure with conductive lines fabricated using selective cap and liner deposition techniques. FIG. 3 illustrates an example of a nanoribbon transistor for which a contact structure may be fabricated using selective cap and liner deposition techniques. FIGS. 4A-4B, 5A-5B, and 6A-6B illustrate cross-sectional side views of examples of IC structures with contact structures fabricated using selective cap and liner deposition techniques. FIGS. 2 and 4-6 each include two figures, labeled with letters A and B (e.g., FIG. 2 includes FIGS. 2A and 2B), providing different cross-sectional side views of a given IC structure. In particular, FIGS. 2 and 4-6 that are labeled with a letter A (e.g., FIG. 2A) illustrate cross-sections in the y-z plane along a plane AA shown in a corresponding figure labeled with a letter B (e.g., along a plane AA shown in FIG. 2B). FIGS. 2 and 4-6 that are labeled with a letter B (e.g., FIG. 2B) illustrate cross-sections in the x-z plane along a plane BB shown in a corresponding figure labeled with a letter A (e.g., along a plane BB shown in FIG. 2A).

Turning first to FIG. 2A, the IC structure 200 includes two conductive lines 229 (one of which is labeled) formed in openings in an insulator material 226. The conductive lines 229 may be in an interconnect layer, such as one of the BEOL layers 154 of FIG. 1. The insulator material 226 may be any suitable insulator material, such as the example ILDs discussed above. One or more layers may be present over the conductive lines (such as the insulator material 238), which may electrically insulate the conductive lines 229 from other conductive lines formed in the next metal layer. One or more of materials formed over the conductive lines 229 may function as etch stop layers to prevent damage to the conductive line 229 during subsequent etch processes. The conductive lines 229 include a conductive fill material 230, such as copper or another suitable conductive material. In one example, the conductive fill material 230 includes an alloy of copper and one or more other elements, such as aluminum or manganese.

In the example illustrated in FIGS. 2A-2B, a liner 232 is present on sidewalls and at a bottom of the openings in which the conductive lines are formed. Although a single liner 232 is shown in FIGS. 2A-2B, the liner 232 may include more than one layer of material. In one such example, the liner 232 may include a material that acts as a barrier layer to prevent diffusion of the conductive fill material 230 into the surrounding insulator material 226. The liner 232 may also or alternatively include a material that acts as an adhesion layer (e.g., to improve adherence of the conductive fill material 230). In one example, the liner 232 may be a ruthenium-based liner. In one such example, the liner includes one or more of: tantalum, tantalum nitride, cobalt, and ruthenium. In one such example, the barrier may include RuTaN, RuCo and TaN (as a multi-layered liner), TaNRu, or TaNRuTaNCo.

The IC structure 200 also includes a conductive layer (e.g., a conductive cap 236) over the conductive fill material 230, where the conductive cap 236 is formed from a different conductive material (e.g., has a different material composition) than the conductive fill material 230. As mentioned briefly above, some existing techniques involve capping metal lines with a cobalt cap. However, forming a cobalt cap over copper lines with a ruthenium-based liner may require forming a very thick layer of cobalt over the lines due to, e.g., absorption of the cobalt into the liner material. A very thick cobalt cap occupies space in the interconnect layer and may have undesirable performance impacts, such as degraded RC delay.

In contrast, the conductive cap 236 may include a novel cap material such as one or more of ruthenium, molybdenum, tungsten, rhodium, iridium, rhenium, and niobium, individually or in combination as alloys (e.g., with cobalt or another element from the preceding cap materials), which may be selectively deposited over the conductive fill material 230 and the liner 232. In one example, the conductive cap material is selectively deposited on the conductive fill material 230 and on the exposed portions of the liner 232 (but not on the surrounding insulator material 226). The dimensions of the conductive cap 236 may vary depending on implementation. In one example, a width of the conductive cap 236 is large enough to encapsulate the conductive fill material 230 (e.g., encapsulate the conductive fill material 230 together with the liner 232). Thus, in one example, the conductive cap 236 is in contact with the liner such that there is not an intervening layer between the material of the conductive cap 236 and one or more materials of the liner 232. In one such example, the width of the conductive cap 236 is equal to about the width of the conductive line plus the width of the liner on both sides, where the width of the conductive cap 236 is a dimension of the conductive cap 236 in a plane substantially parallel to the device region (and substantially parallel to a substrate over which the device region is disposed). In one example, the thickness of the conductive cap 236 may be less than a cobalt-based cap over a ruthenium-based liner. According to examples, the thickness of the conductive cap 236 is in a range of about 0.5-4 nanometers, 0.5-2 nanometers, or 0.5-1 nanometer, where the thickness of the conductive cap 236 is a dimension of the conductive cap 236 in a plane substantially orthogonal to the device region. However, other conductive cap dimensions are possible.

FIG. 2B illustrates the IC structure 200 in the x-z plane, along the plane BB shown in FIG. 2A. As can be seen in FIG. 2B, the conductive fill material 230 of the conductive line 229 is capped with a conductive material (e.g., the conductive cap 236). A via 228 is coupled with the conductive line 229 and with another conductive line (not shown in FIG. 2B) in an interconnect layer above the layer shown in FIG. 2B. Thus, in the example illustrated in FIG. 2B, the conductive cap 236 is between the conductive fill material 230 and the via 228.

Thus, FIGS. 2A-2B illustrate an example of selective conductive cap and liner deposition techniques in the context of conductive interconnects. As mentioned above, selective conductive cap and liner deposition techniques may also be used to form liners and/or conductive caps for contact structures (e.g., an S/D contact structure for a transistor). Fabrication of IC structures using selective conductive cap and liner deposition techniques may be carried out with transistors of any architecture, such as any non-planar or planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

Nanoribbon transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). Therefore, some IC structures illustrated herein show nanoribbon transistors as an example (e.g., IC structures shown in FIG. 3, FIGS. 4A-4B, FIGS. 5A-5B, and FIGS. 6A-6B), although fabrication using selective conductive cap and liner techniques, described herein, is not limited to such transistors.

As used herein, the term "nanoribbon" refers to an elongated structure of a semiconductor material having a longitudinal axis parallel to a support structure (e.g., a substrate, a die, a chip, or a wafer) over which such a structure is built. Typically, a length of a such a structure (i.e., a dimension measured along the longitudinal axis, shown in the present drawings to be along the y-axis of an example x-y-z coordinate system 305 shown in FIG. 3) is greater than each of a width (i.e., a dimension measured along the x-axis of the coordinate system 305) and a thickness/height (i.e., a dimension measured along the z-axis of the coordinate system 305). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain regions of a transistor provided on either side of the channel material.

FIG. 3 provides a perspective view of an example IC structure 300 with a nanoribbon transistor 310, according to some embodiments of the present disclosure. As shown in FIG. 3, the IC structure 300 includes a semiconductor material formed as a nanoribbon 304 extending substantially parallel to a support 302. The transistor 310 may be formed on the basis of the nanoribbon 304 by having a gate stack 306 wrap around at least a portion of the nanoribbon referred to as a "channel portion" and by having source and drain regions, shown in FIG. 3 as a first S/D region 314-1 and a second S/D region 314-2, on either side of the gate stack 306. One of the S/D regions 314 is a source region and the other one is a drain region. However, because, as is common in the field of FETs, designations of source and drain are often interchangeable, they are simply referred to herein as a first S/D region 314-1 and a second S/D region 314-2.

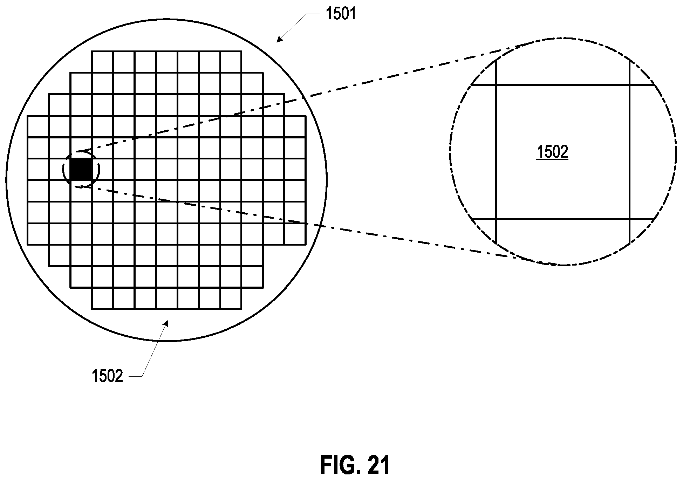

Implementations of the present disclosure may be formed or carried out on any suitable support 302, such as a substrate, a die, a wafer, or a chip. The support 302 may, e.g., be the wafer 1501 of FIG. 21, discussed below, and may be, or be included in, a die, e.g., the singulated die 1502 of FIG. 21, discussed below. The support 302 may be a semiconductor substrate, such as those discussed above with respect to FIG. 1. Although only one nanoribbon 304 is shown in FIG. 3, the IC structure 300 may include a stack of such nanoribbons where a plurality of nanoribbons 304 are stacked above one another, e.g., as is shown in FIG. 4A-4B, showing IC structures that may be examples of the IC structure 300. In some embodiments, a portion of the support 302 right below the lowest nanoribbon 304 of the stack may be shaped as a subfin extending away from a base, as is known in the field of nanoribbon transistors.

The nanoribbon 304 may take the form of a nanowire or nanoribbon, for example. In some embodiments, an area of a transversal cross-section of the nanoribbon 304 (i.e., an area in the x-z plane of an x-y-z coordinate system 305 shown in FIG. 3, perpendicular to a longitudinal axis 320 of the nanoribbon 304) may be between about 25 and 10000 square nanometers, including all values and ranges therein (e.g., between about 25 and 1000 square nanometers, or between about 25 and 500 square nanometers). In some embodiments, a width of the nanoribbon 304 (i.e., a dimension measured in a plane parallel to the support 302 and in a direction perpendicular to the longitudinal axis 320 of the nanoribbon 304, e.g., along the x-axis of the coordinate system 305) may be at least about 3 times larger than a height of the nanoribbon 304 (i.e., a dimension measured in a plane perpendicular to the support 302, e.g., along the z-axis of the coordinate system 305), including all values and ranges therein, e.g., at least about 4 times larger, or at least about 5 times larger. Although the nanoribbon 304 illustrated in FIG. 3 is shown as having a rectangular cross-section, the nanoribbon 304 may instead have a cross-section that is rounded at corners or otherwise irregularly shaped, and the gate stack 306 may conform to the shape of the nanoribbon 304. The term "face" of a nanoribbon may refer to the side of the nanoribbon 304 that is larger than the side perpendicular to it (when measured in a plane substantially perpendicular to the longitudinal axis 320 of the nanoribbon 304), the latter side being referred to as a "sidewall" of a nanoribbon.

In various embodiments, the semiconductor material of the nanoribbon 304 may be composed of semiconductor material systems including, for example, N-type or P-type materials systems. In some embodiments, the nanoribbon 304 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 304 may include a combination of semiconductor materials. In some embodiments, the nanoribbon 304 may include a monocrystalline semiconductor, such as silicon (Si) or germanium (Ge). In some embodiments, the nanoribbon 304 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 310 is an N-type metal-oxide-semiconductor (NMOS) transistor), the channel material of the nanoribbon 304 may include a III-V material having a relatively high electron mobility, such as, but not limited to InGaAs, InP, InSb, and InAs. For some such embodiments, the channel material of the nanoribbon 304 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 310 is a P-type metal-oxide-semiconductor (PMOS) transistor), the channel material of the nanoribbon 304 may advantageously be a group IV material having a high hole mobility, such as, but not limited to Ge or a Ge-rich SiGe alloy. For some example embodiments, the channel material of the nanoribbon 304 may have a Ge content between 0.6 and 0.9, and advantageously may be at least 0.7.

In some embodiments, the channel material of the nanoribbon 304 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 304 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 304 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

A gate stack 306 including a gate electrode material 308 and, optionally, a gate insulator material 312, may wrap entirely or almost entirely around a portion of the nanoribbon 304 as shown in FIG. 3, with the active region (channel region) of the channel material of the transistor 310 corresponding to the portion of the nanoribbon 304 wrapped by the gate stack 306. As shown in FIG. 3, the gate insulator material 312 may wrap around a transversal portion of the nanoribbon 304 and the gate electrode material 308 may wrap around the gate insulator material 312.

The gate electrode material 308 may include one or more gate electrode materials, where the choice of the gate electrode materials may depend on whether the transistor 310 is a PMOS transistor or an NMOS transistor. For a PMOS transistor, gate electrode materials that may be used in different portions of the gate electrode material 308 may include, but are not limited to, ruthenium, palladium, platinum, cobalt, nickel, and conductive metal oxides (e.g., ruthenium oxide). For an NMOS transistor, gate electrode materials that may be used in different portions of the gate electrode material 308 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 308 may include a stack of a plurality of gate electrode materials, where zero or more materials of the stack are workfunction (WF) materials and at least one material of the stack is a fill metal layer. Further materials/layers may be included next to the gate electrode material 308 for other purposes, such as to act as a diffusion barrier layer or/and an adhesion layer.

In some embodiments, the gate insulator material 312 may include one or more high-k dielectrics including any of the materials discussed herein with reference to the insulator material that may surround portions of the transistor 310. In some embodiments, an annealing process may be carried out on the gate insulator material 312 during fabricate of the transistor 310 to improve the quality of the gate insulator material 312. The gate insulator material 312 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 306 may be surrounded by a gate spacer, not shown in FIG. 3. Such a gate spacer would be configured to provide separation between the gate stack 306 and S/D contacts of the transistor 310 and could be made of a low-k dielectric material, some examples of which have been provided above.

Turning to the S/D regions 314 of the transistor 310, in some embodiments, the S/D regions may be highly doped, e.g., with dopant concentrations of about 10²¹ cm⁻³, in order to advantageously form Ohmic contacts with the respective S/D contacts (not shown in FIG. 3), although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 314-1 and the second S/D region 314-2), and, therefore, may be referred to as "highly doped" (HD) regions. Even when doped to realize threshold voltage tuning as described herein, the channel portions of transistors typically include semiconductor materials with doping concentrations significantly smaller than those of the S/D regions 314.

The S/D regions 314 of the transistor 310 may generally be formed using either an implantation/diffusion process or an etching/deposition process. In the former process, dopants such as boron, aluminum, antimony, phosphorous, or arsenic may be ion-implanted into the nanoribbon 304 to form the source and drain regions. An annealing process that activates the dopants and causes them to diffuse further into the nanoribbon 304 may follow the ion implantation process. In the latter process, portions of the nanoribbon 304 may first be etched to form recesses at the locations of the future S/D regions 314. An epitaxial deposition process may then be carried out to fill the recesses with material that is used to fabricate the S/D regions 314. In some implementations, the S/D regions 314 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 314 may be formed using one or more alternate semiconductor materials such as germanium or a group III-V material or alloy. And in further embodiments, one or more layers of metal and/or metal alloys may be used to form the S/D regions 314. In some embodiments, a distance between the first and second S/D regions 314 (i.e., a dimension measured along the longitudinal axis 320 of the nanoribbon 304) may be between about 5 and 40 nanometers, including all values and ranges therein (e.g., between about 22 and 35 nanometers, or between about 20 and 30 nanometers).

The IC structure 300 shown in FIG. 3, as well as IC structures shown in other drawings of the present disclosure, is intended to show relative arrangements of some of the components therein, and the IC structure 300, or portions thereof, may include other components that are not illustrated (e.g., electrical contacts to the S/D regions 314 of the transistor 310, additional layers such as a spacer layer around the gate electrode of the transistor 310, etc.). For example, although not specifically illustrated in FIG. 3, a dielectric spacer may be provided between a first S/D contact (which may also be referred to as a "first S/D electrode") coupled to a first S/D region 314-1 of the transistor 310 and the gate stack 306 as well as between a second S/D contact (which may also be referred to as a "second S/D electrode") coupled to a second S/D region 314-2 of the transistor 310 and the gate stack 306 in order to provide electrical isolation between the source, gate, and drain electrodes. In another example, although not specifically illustrated in FIG. 3, at least portions of the transistor 310 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 310 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

FIGS. 4A-4B illustrate an example IC structure 400 including a nanoribbon transistor and a conductive contact structure formed with selective cap and liner deposition techniques.

As shown in FIG. 4A, the IC structure 400 includes a transistor similar to the transistor 310 of FIG. 3 but built on the basis of a nanoribbon stack 404 of a plurality of nanoribbons 304 instead of just one nanoribbon 304 as shown in FIG. 3. While four nanoribbons 304 are shown to be included in the nanoribbon stack 404, in other embodiments, fewer nanoribbons or more nanoribbons may be included. FIG. 4A illustrates a semiconductor material 403 as the material of the nanoribbons 304, further illustrating a subfin 405 of the semiconductor material 403 below the nanoribbon stack 404, although in some embodiments the nanoribbons 304 and at least a portion of the subfin 405 may include semiconductor materials of different material compositions. In some examples, some or all of the subfin 405 may be removed and replaced with another material, such as an insulator material. As shown in FIG. 4A, a gate stack 306 having a gate insulator material 312 and a gate electrode material 308 may wrap around channel portions of the nanoribbons 304. FIG. 4A further illustrates a first S/D region 314-1 and a second S/D region 314-2 extending through the nanoribbon stack 404, electrically insulated/separated from the gate electrode material 308 and from the semiconductor material 403 of the subfin 405 by an insulator material 407. In some embodiments, the insulator material 407 may form so-called "dimples" 409 in areas where the insulator material 407 separates the S/D regions 314 from the gate electrode material 308. The insulator material 407 may include any of the insulator materials described herein, e.g., any of the ILD materials described above.

Above the nanoribbon stack 404, FIG. 4A illustrates a gate contact 406 and S/D contacts 414 on either side of the gate contact 406, individually labeled as a first S/D contact 414-1 for making electrical contact to the first S/D region 314-1 and a second S/D contact 414-2 for making electrical contact to the second S/D region 314-2. The gate contact 406 may include an electrically conductive material 415 in electrically conductive contact with the gate electrode material 308. In various embodiments, material compositions of the electrically conductive material 415 and the gate electrode material 308 may be substantially the same or different.

The S/D contacts 414 may be electrically isolated from the gate electrode material 308 and the electrically conductive material 415 of the gate contact 406 by gate spacers 408. The gate spacers 408 may include one or more of spacer materials, diffusion barrier materials, adhesion materials, etc., as known in the art for forming contacts to various components of IC structures. In some embodiments, the gate spacers 408 may include low-k dielectrics and/or any of the ILD materials described above.

Within the sidewalls of the contact openings, the S/D contacts 414 may be filled with an electrically conductive fill material 417. In various embodiments, material compositions of the electrically conductive fill material 417 and the electrically conductive material 415 may be substantially the same or different. In some examples, the conductive fill material 417 may be or include tungsten, ruthenium, or another conductive material.

At the bottom of the S/D contacts 414, an interface material 416 is deposited to provide an interface between the S/D regions 314 and the electrically conductive fill material 417 of S/D contacts 414. The interface material 416 may include/be a metal such as titanium which, once deposited, may intermix with the material of the S/D regions 314, e.g., with silicon, forming a compound (e.g., titanium silicide) that may help reduce contact resistance of the S/D contacts 414. In another example, silicon and another material (e.g., titanium) may both be used as precursors to reduce the consumption of silicon from the S/D regions 314 to form the layer of silicide. During fabrication, the interface material 416 may be deposited within openings for future S/D contacts 414 using selective deposition, where the interface material 416 is deposited onto the bottom of the openings for the S/D contacts 414 but not on the sidewalls of the openings for the S/D contacts 414. In other examples, the interface material 416 may also be deposited on sidewalls of the contact openings in addition to at the bottom of the contact openings (e.g., as shown in FIG. 17B, discussed below).

The IC structure 400 illustrated in FIG. 4A also includes a conductive cap 421 over the interface material 416. In the example illustrated in FIG. 4A, the conductive cap 421 is a selectively deposited conductive cap that is deposited only on the interface material 416 and not on the sidewalls of the opening or on the insulator material 426. Thus, in the example illustrated in FIG. 4A, the width of the cap is substantially the same as the width of the interface material 416, where the width of the conductive cap 421 is a dimension of the conductive cap 421 in a plane substantially parallel to the support 302. In one example, a thickness of the conductive cap 421 is in a range of about 4-10 nanometers or about 5-7 nanometers, where the thickness of the conductive cap 421 is a dimension of the conductive cap 421 in a plane that is substantially orthogonal to the support 302. In one example, the conductive cap include one or more of ruthenium, molybdenum, tungsten, rhodium, iridium, platinum, rhenium, cobalt, and niobium either individually or as an alloy.

In some examples, the conductive cap 421 and the conductive fill material 417 may have substantially the same material composition. For example, the conductive cap 421 and the conductive fill material 417 may both be or include ruthenium. In one such example, there may or may not be visible differences between the conductive fill material 417 and the conductive cap 421. For example, an interface may be present between the conductive fill material 417 and the conductive cap 421. In one example, the conductive cap 421 and the conductive fill material 417 may have differences in purity and/or crystallinity. For example, the conductive cap 421 may have a smaller grain size (e.g., the conductive cap 421 may be more nanocrystalline) than the conductive fill material 417, which may have a larger grain size relative to the conductive cap 421. In another example, depending on the technique used to deposit the conductive cap 421, the conductive cap 421 may have carbon impurities (e.g., resulting from a CVD or ALD process) that are absent in the conductive fill material 417 (which may be deposited using a different process, such as a PVD process).

FIG. 4B provides another illustration of the IC structure 400 along the plane BB shown in FIG. 4A (i.e., a cut across the S/D region 314-2). FIG. 4B illustrates the S/D region 314-2 in the x-z plane. As can be seen in FIG. 4B, the selectively deposited conductive cap 421 is substantially absent from sidewalls and absent from over the insulator material 426.

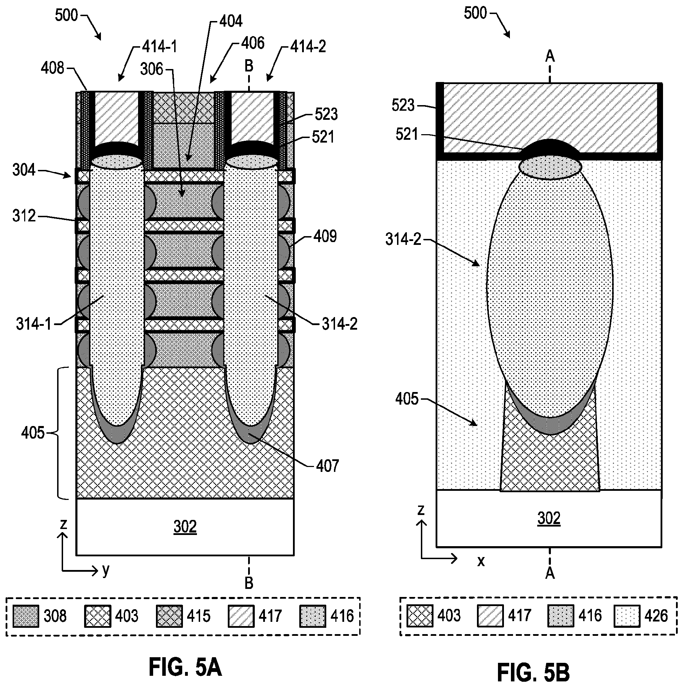

In other examples, a conductive material (e.g., the material of the selective conductive cap 421 or another conductive material) may also be present on sidewalls of the contact openings and over the ILD 326. For example, FIGS. 5A-5B illustrate another example IC structure 500 that includes a conductive material forming a cap 521 and a liner 523 on sidewalls of the contact openings. FIGS. 5A-5B are similar to FIGS. 4A-4B in that the IC structure 500 shown in FIG. 5A includes a conductive cap 521 between the interface material 416 and the conductive fill material 417 of the contact structure; however, the IC structure 500 of FIG. 5A differs from the IC structure 400 of FIG. 4A in that the IC structure 500 also includes the conductive material of the cap 521 on sidewalls of the contact openings. Thus, the IC structure includes a conductive cap 521 and a liner 523 on sidewalls of the contact opening. The conductive cap 521 and liner 523 may include one or more of the conductive materials described above with respect to the cap 421 (e.g., the conductive cap 521 and liner 523 may be or include ruthenium, molybdenum, or another suitable conductive material). The liner 523 may protect the insulator material 426 from metallization byproducts and may provide further protection of the bottom contact metal from process damage and oxidation from exposure to air and subsequent processing.

The liner 523 and conductive cap 521 may be deposited with the same process or with different processes. For example, the conductive cap 521 may first be selectively deposited, and then a non-selective layer of the conductive material may be deposited on sidewalls and at a bottom of the contact openings. In another example, a partially selective process that has a selectivity ratio in a range of about 7:1 to 10:1 may be used to deposit a layer of conductive material on the interface material 416 at the bottom that is thicker than the layer on the sidewalls. For example, the conductive material deposited on the interface material 416 may have a first thickness and a layer of the conductive material on the sidewalls may have a second thickness, where a ratio of the first thickness to the second thickness is in a range of about 7:1 or 10:1. The conductive cap 521 and liner 523 are shown in FIGS. 5A-5B as having the same material composition. In an example in which the liner 523 and the conductive cap 521 have substantially the same material composition but were deposited in two different processes, an interface between the selectively deposited cap and the liner may or may not be visible.

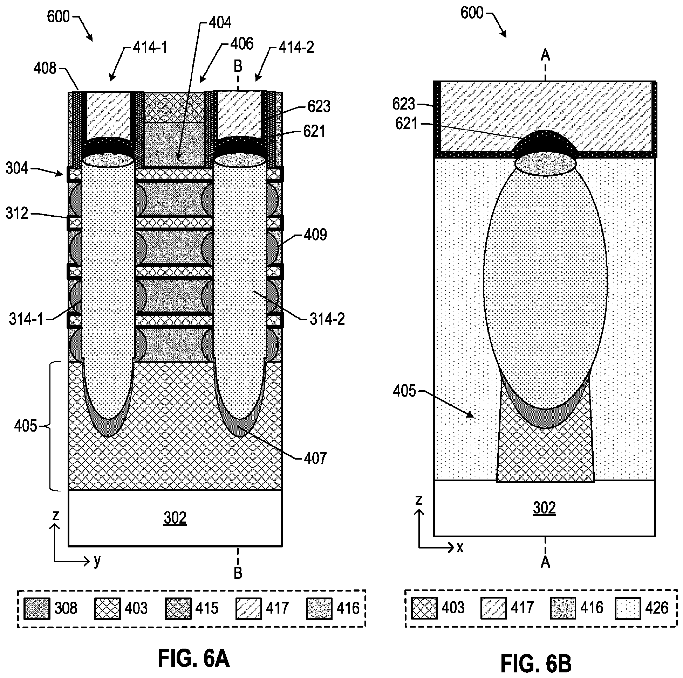

In other examples, a selective cap may first be deposited over the interface material 416 followed by deposition of a liner of a conductive material with a different material composition than the conductive cap. For example, FIGS. 6A-6B illustrate another example IC structure 600 that includes a cap 621 formed from one conductive material and a liner 623 formed from another conductive material on sidewalls of the contact openings and over the cap 621. In one such example, the conductive cap 621 may include one or more of the conductive materials described above with respect to the cap 421, and the liner 623 may include one or more other conductive materials described above with respect to the cap 421. In one example, the conductive cap may include ruthenium, and the liner may include one or more of molybdenum, tungsten, rhodium, iridium, platinum, rhenium, cobalt, and niobium. In another example, the liner 623 includes ruthenium, and the conductive cap 621 includes one or more of molybdenum, tungsten, rhodium, iridium, platinum, rhenium, cobalt, and niobium. In another example, both the liner 623 and the cap 621 include ruthenium, but the liner 623 or the cap 621 includes another element (e.g., as an alloy) so that the conductive cap 621 and the liner 623 have different material compositions.

Depending on implementation, the liner 623 may be a conformal liner (e.g., having substantially the same thickness at a bottom of the contact opening and on the sidewalls of the contact openings), or may be thicker at a bottom of the contact openings than on the sidewalls. In one example, the liner 623 has a thickness at the bottom of the contact openings (e.g., a thickness over the cap 621) and/or a thickness on the sidewalls that is smaller than a thickness of the conductive cap 621. In one such example, the cap 621 may protect the interface material 416 from, e.g., oxidation and/or the subsequent metallization process, and the thin liner 623 may protect the ILD from the metallization process and also provide additional protection to the interface material 416.

Thus, FIGS. 4A-4B, 5A-5B, and 6A-6B illustrate various examples of IC structures with a metal/silicon contact structure and a selective conductive cap between the interface material (e.g., silicide) and conductive fill material of the contact structure. Selective deposition of the conductive cap may result in the conductive cap material being deposited primarily (or only) on the interface material to protect the interface material without occupying excessive space on sidewalls of the contact opening. In one example, the conductive cap material has a first thickness between the interface material and the conductive fill material, and the conductive cap material is present on sidewalls of the contact opening with a second thickness of at most 15% of the first thickness. Thus, for IC structures with a metal/silicon contact structure, a selective conductive cap between the interface material may protect the interface material from subsequent oxidation and/or processing, and may result in improved reliability and performance.

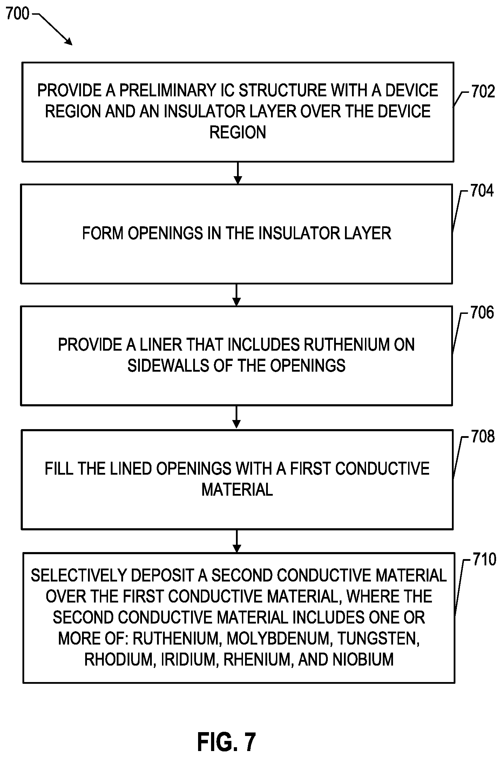

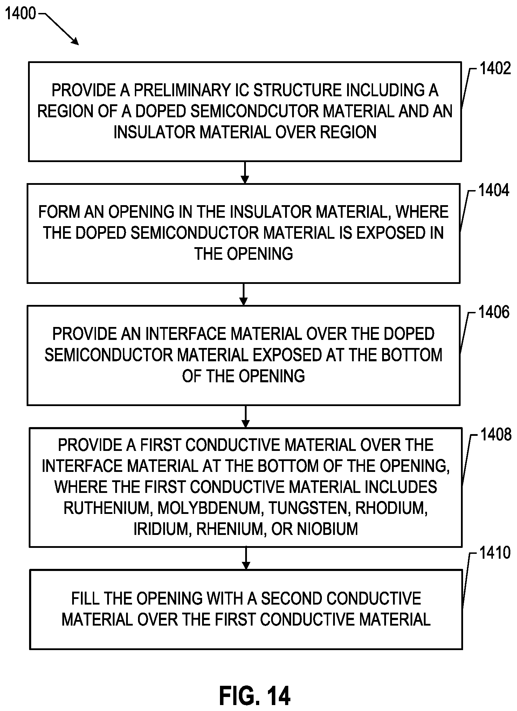

FIGS. 7 and 14 are flow diagrams of example methods for fabricating IC structures using selective conductive cap and liner deposition techniques, in accordance with some embodiments. FIG. 7 illustrates an example method of fabricating an IC structure with selective conductive cap deposition techniques over a conductive line (e.g., in an BEOL/interconnect layer). FIG. 14 illustrates an example method of fabricating an IC structure with selective conductive cap deposition techniques in a contact structure (e.g., in a FEOL layer). Although the operations of the methods of FIGS. 7 and 14 are illustrated once each and in a particular order, the operations may be performed in any suitable order and repeated as desired. For example, one or more operations may be performed in parallel to fabricate multiple IC structures using selective conductive cap and liner deposition techniques substantially simultaneously. In another example, the operations may be performed in a different order to reflect the structure of an IC device in which selective conductive cap and liner deposition techniques will be implemented.

In addition, the example fabricating methods of FIGS. 7 and 14 may include other operations not specifically shown in FIGS. 7 and 14, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the methods of FIGS. 7 and 14 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

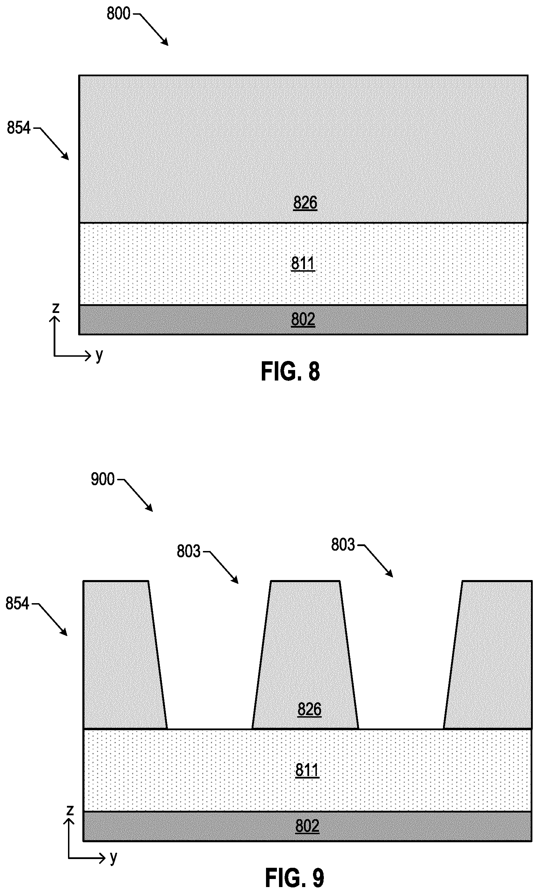

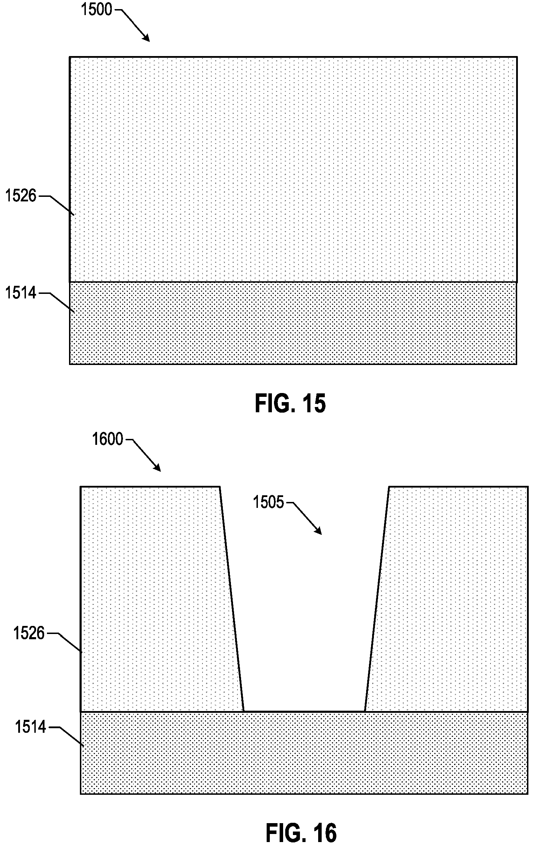

FIGS. 8-13 provide cross-sectional side views at various stages in the fabrication of an example IC structure according to the method of FIG. 7, in accordance with some embodiments. FIGS 15-16, 17A-17B, 18A-18D, and 19A-19D provide cross-sectional side views at various stages in the fabrication of an example IC structure according to the method of FIG. 14, in accordance with some embodiments. FIGS. 17-19 include figures labeled with letters A and B or A, B, C, and D (e.g., FIG. 17 includes FIGS. 17A and 17B), illustrating different IC structures resulting from variations of the method 14, as is explained in more detail with reference to those figures.

Turning to FIG. 7, the method 700 begins with a process 702 of providing a preliminary IC structure with a device region and an insulator layer over the device region. The IC structure 800 of FIG. 8 illustrates an example result of the process 702. As can be seen in FIG. 8, the preliminary IC structure 800 includes a device region 811 over a substrate 802, and a layer of an insulator material 826 over the device region 811. The device region 811 may be an example of the device region 111 of FIG. 1, and the substrate 802 may be an example of the substrate 102 of FIG. 1. The insulator material 826 may be any suitable insulator material, such as the ILDs discussed above. The insulator material may be in a BEOL layer 854.

The method 700 continues with the process 704 of forming openings in the insulator layer. The IC structure 900 of FIG. 9 illustrates an example result of the process 704. As can be seen in FIG. 9, openings 803 have been formed in the insulator layer. The openings 803 shown in FIG. 9 are depicted as trenches that extend into and out of the page (e.g., along the x-axis as shown in FIG. 9), but forming openings in the insulator material 826 may involve forming trenches (e.g., for conductive lines) and/or holes (e.g., for conductive vias). Any suitable etch technique may be used to form the openings 803, such as a dry etch, e.g., radio frequency (RF) reactive ion etch (RIE) or inductively coupled plasma (ICP) RIE, or other suitable etch technique. A conductive element (not shown in FIG 9) in the device region 811 may be exposed at the bottom of an opening 803 to enable electrically coupling the conductive line formed in the opening 803 with a device in the device region 811.

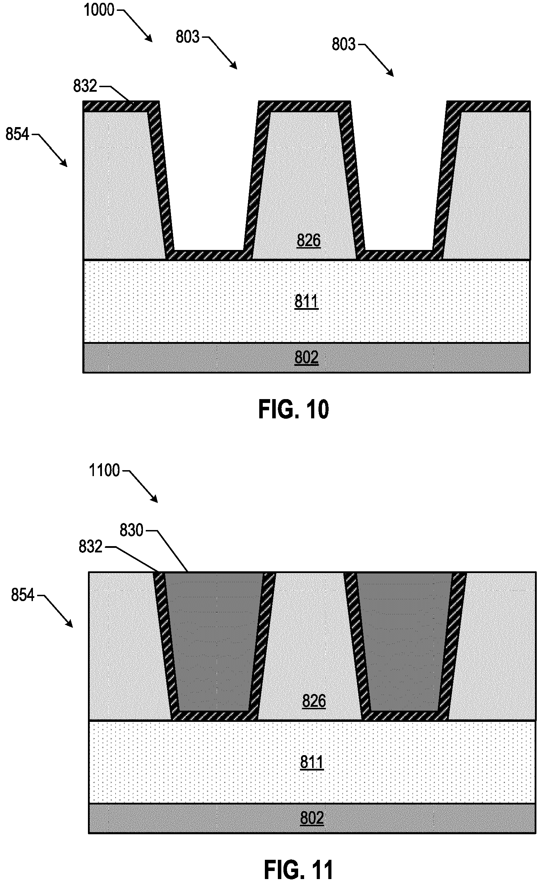

The method 700 continues with the process 706 of providing a liner that includes ruthenium on sidewalls of the opening. The IC structure 1000 of FIG. 10 illustrates an example result of the process 706. As can be seen in FIG. 10, the IC structure 1000 includes a liner 832 on sidewalls and at the bottom of the openings 803 in the insulator material 826. The liner 832 may also be deposited on a top exposed surface of the insulator material 826. The liner 832 may be deposited with any suitable technique, such as atomic layer deposition (ALD), chemical vapor deposition (CVD), metalorganic chemical vapor deposition (MOCVD), plasma enhanced CVD (PECVD), physical vapor deposition (PVD) such as sputter, electroplating, electroless plating, or other suitable technique. The liner 832 may be an example of the liner 232 of FIGS. 2A-2B, and may be conformal, or may have varying thicknesses on the sidewalls and at the bottom of the openings 803. In one example, the liner 832 may include tantalum, nitrogen, and ruthenium (e.g., TaNRu, RuTaN, or TaNRuTaN) or tantalum, nitrogen, ruthenium, and cobalt (e.g., TaNRuTaNCo), and may include a multi-layered liner (e.g., a layer of TaN and a layer of RuCo). In an example of a multi-layered liner, one layer may act as a barrier layer (e.g., a diffusion barrier), and another layer may act as an adhesion layer (e.g., to improve deposition of the conductive fill material). In one example in which a single-layered liner is used, the material may act as both a barrier layer and an adhesion layer.

The method 700 continues with the process 708 of filling the lined openings with a conductive material. The IC structure 1100 of FIG. 11 illustrates an example result of the process 708. As can be seen in FIG. 11, the lined openings 803 are filled with the conductive material 830, such as copper, or another suitable conductive material. In some examples, the conductive fill material 830 may be an alloy (e.g., an alloy of copper and one or more other metals, such as aluminum or manganese). The conductive material 830 may be deposited with any suitable technique, e.g., atomic layer deposition (ALD), chemical vapor deposition (CVD), plasma enhanced CVD (PECVD), physical vapor deposition (PVD) such as sputter, electroplating, electroless plating, or other suitable technique. In some examples, an overburden of the conductive material 830 and the liner 832 present on a top surface of the insulator material 826 may be removed (e.g., with a CMP process). After performing a polish to remove the overburden of the conductive fill material 430 and liner material, in some examples, a process to clean the surface of IC structure may be performed, such as a reducing or chemical pre-clean process. In some examples, a pre-clean process may involve one or more of a hydrogen plasma, radical reduction, chemical oxide, and residue removal.

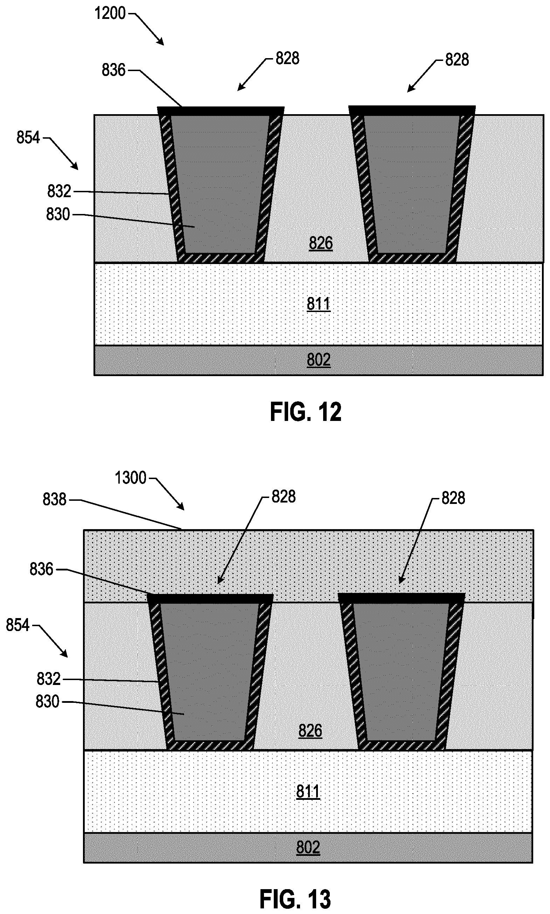

The method 700 continues with the process 710 of selectively depositing a conductive cap material over the conductive fill material. The IC structure 1200 of FIG. 12 illustrates an example result of the process 710. As can be seen in FIG. 12, the conductive cap material may form a conductive cap 836 over the conductive fill material 830 and over the liner 832. In some examples, the conductive cap 836 may include one or more ruthenium, molybdenum, tungsten, rhodium, iridium, rhenium, and niobium, individually or in combination as alloys. In example, the conductive cap includes an alloy of cobalt and one or more of ruthenium, molybdenum, tungsten, rhodium, iridium, rhenium, and niobium. In the example illustrated in FIG. 12, the capping material is deposited only (or primarily) on metallic materials (e.g., metals, alloys, metal nitrides, etc.), and thus is deposited over the conductive fill material 830 and the liner 832, but not on the insulator material 826. The conductive cap 836 may be deposited using any suitable deposition technique, including, for example, ALD, CVD, MOCVD, electroless plating, or other suitable deposition technique. Processes may be partially or fully selective, and can use inherent selective deposition or combined with inhibitors and suppressor processing to selectively deposit the selective cap 836. In one example, the cap material fully encapsulates the copper or copper-alloy conductor portion of the conductive lines and barrier and/or liner portions. The method may continue with additional processing, e.g., to form additional interconnect layers. For example, as can be seen in FIG. 1300, the IC structure 1300 includes a layer 838 (e.g., a layer of an insulator material and/or an etch stop layer) over the capped conductive lines to facilitate in forming additional interconnect layers. One or more additional interconnect layers may also include a liner and/or cap such as the liner 832 and selectively deposited conductive cap 836 of FIG. 13.

Thus, the method 700 of FIG. 7 is an example method of fabricating an IC structure with conductive interconnects with a selectively deposited conductive cap in accordance with examples described herein. FIG. 14 is a flow diagram another method 1400 of fabricating an IC structure with selective cap and liner deposition techniques, but for a contact structure (e.g., in a FEOL layer) instead of a conductive line in a BEOL layer.

Turning to FIG. 14, the method 1400 begins with a process 1402 of providing a preliminary IC structure with a region of a doped semiconductor material (e.g., a source or drain region of a transistor) and an insulator material over the region of a doped semiconductor material. The IC structure 1500 of FIG. 15 illustrates an example result of the process 1402. As can be seen in FIG. 15, the IC structure 1500 includes a region of a doped semiconductor material 1514 and an insulator material 1526 over the doped semiconductor material 1514. In one example, the region of a doped semiconductor material 1514 is an example of the S/D regions 314-1 or 314-2 of the IC structure 400, discussed above. The method 1400 continues with the process 1404 of forming an opening in the insulator material, where the doped semiconductor material is exposed in the opening. The IC structure 1600 of FIG. 16 illustrates an example result of the process 1404. As can be seen in FIG. 16, the IC structure 1600 includes an opening 1505 in the insulator material 1526 that exposes a portion of the doped semiconductor material 1514. The opening may be formed with any suitable etching process, such as those discussed above with respect to the process 704 of FIG. 7. In some examples, the exposed semiconductor material may be cleaned prior to subsequent processing (e.g., using chemical, plasma, or radical-based cleaning).

The method 1400 continues with the process 1406 of providing an interface material over the doped semiconductor material exposed at the bottom of the opening. The IC structures 1700A and 1700B of FIGS. 17A-17B illustrate different example results of the process 1406. FIG. 17A illustrates an example IC structure in which a fully selective process has been used to form the interface material. FIG. 17B illustrates an example in which a partially selective process has been used to form the interface material. As can be seen in FIG. 17A, the IC structure 1700A includes a layer of an interface material selectively deposited at the bottom of the opening 1505, but not on the sidewalls of the opening. The IC structure 1700B of FIG. 17B also includes the interface material on sidewalls of the opening 1505 in addition to at the bottom of the opening 1505. In one example, a partially selective process to form the layer of interface material 1516 may have a selectivity ratio in a range of about 3.5:1 to 8:1, or 3.5:1 to 7:1. Other selectivity ratios are possible (e.g., >8:1). The interface material may include, for example, a silicide. In one example, a silicide may be formed by depositing a metal over the exposed portion of the doped semiconductor material 1514, which intermixes with the doped semiconductor material 1514 to form a metal silicide. In other examples, a semiconductor material may be included in the precursor chemistry to limit the consumption of the doped semiconductor material 1514 to form the silicide. The material deposited over the doped semiconductor material 1514 may include, for example, Ti, TiSi, TiPx, TiBx, TiSixPy, TiSixBy, MoBx, or WBx. In one example, the material may be deposited using a co-flow or sequential cycles of some or all of the metal precursor, H₂, dopant, and may involve a thermal or plasma-enhanced deposition process.

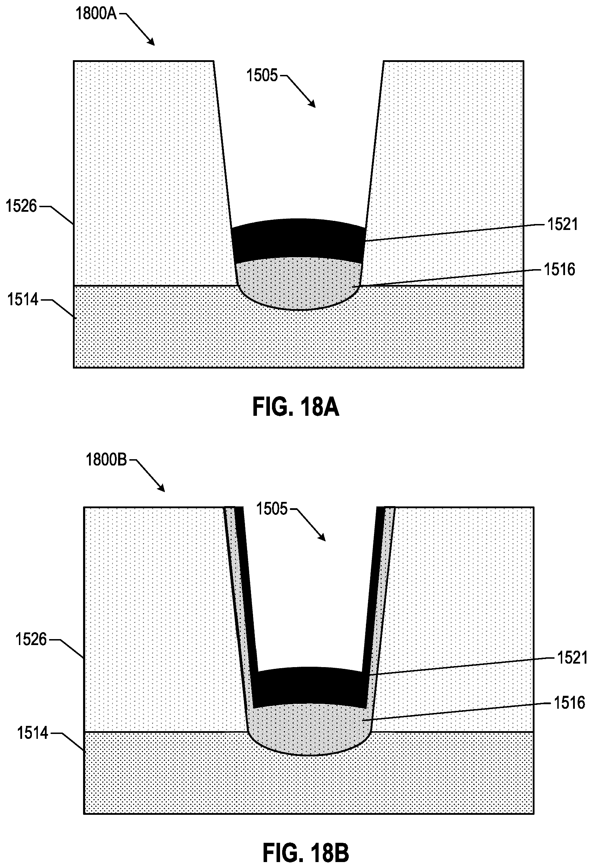

The method 1400 continues with the process 1408 of providing a first conductive material (e.g., a conductive cap material) over the interface material at the bottom of the opening, where the first conductive material includes one or more of ruthenium, molybdenum, tungsten, rhodium, iridium, rhenium, or niobium. The IC structures 1800A-1800D of FIGS. 18A-18D illustrate different example results of the process 1408. As can be seen in FIGS. 18A and 18B, a conductive cap 1521 is selectively deposited on the interface material 1516. In the example illustrated in FIG. 18A, the interface material 1516 is limited to the bottom of the opening 1505, and therefore the conductive cap is deposited only at the bottom of the opening 1505 on the interface material 1516 (and not on the sidewalls of the opening 1505). In contrast, in FIG. 18B, the interface material 1516 is present on the sidewalls of the opening 1505, and the conductive cap is deposited on both the bottom and the sidewalls of the openings 1505. The conductive material may be deposited with any suitable deposition technique, such as ALD, CVD, MOCVD, electroless plating, or other suitable deposition technique. Processes may be partially or fully selective, and can use inherent selective deposition or combined with inhibitors and suppressor processing to selectively deposit the selective cap 1521. In one example, the conductive cap 1521 may be deposited with a selective deposition process with a selectivity ratio in a range of at least 7:1 and 10:1.

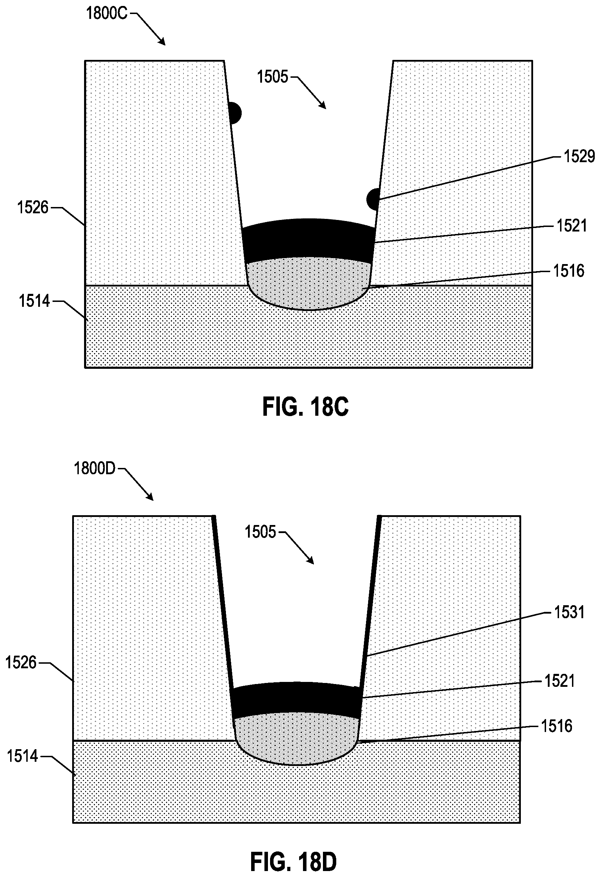

FIGS. 18C and 18D illustrate examples of IC structures 1800D and 1800D in which the selective deposition process to deposit a cap over the interface material 1516 is not perfectly selective, resulting in the conductive cap material on the sidewalls of the opening 1505. In the example illustrated in FIG. 18C, there are nucleation points 1529 where the deposition process has lost selectivity and the conductive material as started to grow on the sidewalls of the opening 1505 (e.g., on the insulator material 1526 on the sidewalls of the opening 1505). In the example illustrated in FIG. 18C, the nucleation points may appear as hemispheric areas (e.g., having a radius of about 1/10^{th} the thickness of growth at the bottom of the opening 1505) of the conductive cap material on the sidewalls. FIG. 18D illustrates another example of an IC structure 1800D in which the conductive cap material may be deposited as a thin layer or liner 1531 on the sidewalls of the opening 1505 (e.g., on the insulator material 1526 on the sidewalls of the opening 1505). Thus, in some examples, there may be regions on the sidewalls with the conductive material in addition to the conductive cap 1521 at the bottom of the opening. In one such example, the thickness of the conductive material on the sidewalls is at most about 15% of the thickness at the bottom of the opening 1505.

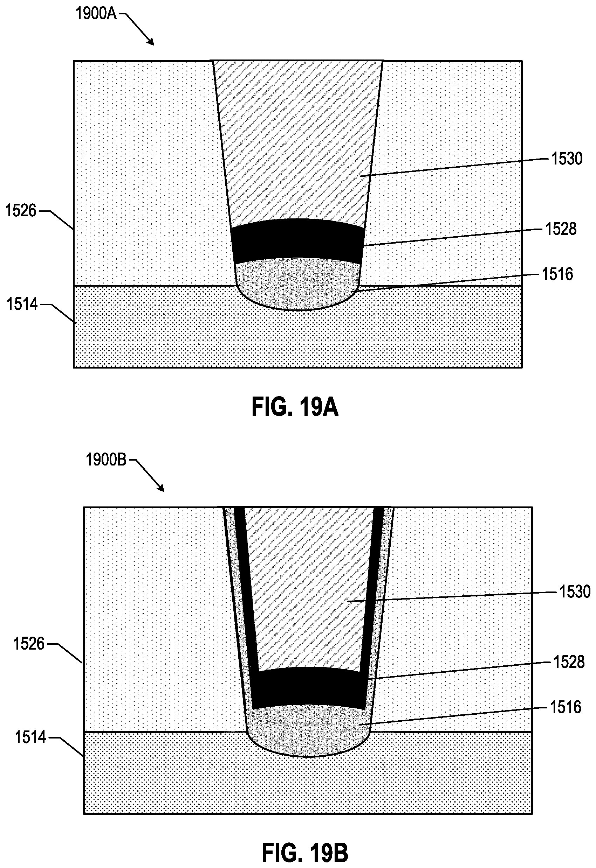

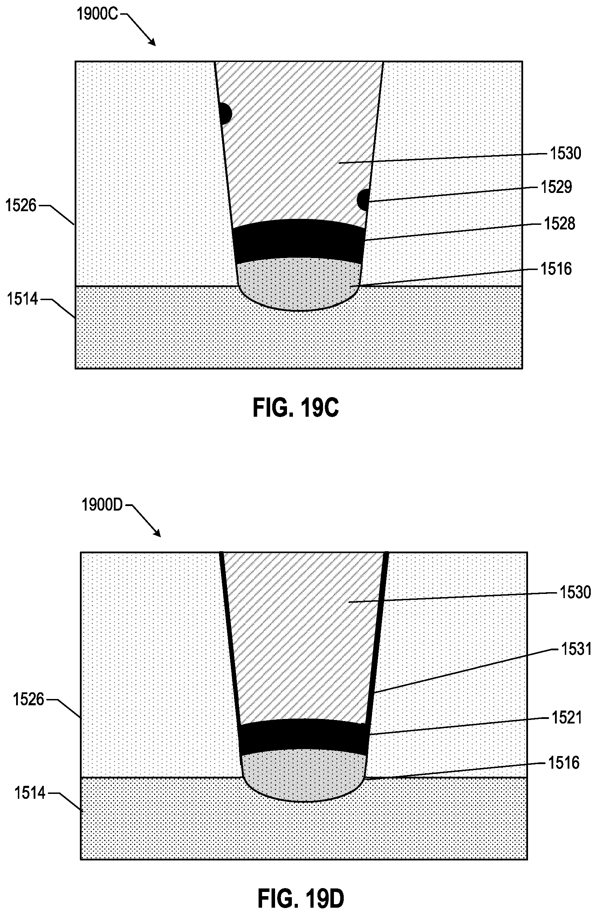

The method 1400 continues with the process 1410 of filling the opening with a second conductive material over the first conductive material. The IC structures 1900A-100D of FIGS. 19A-19D illustrate example results of the process 1410. As can be seen in FIGS. 19A-19D, the opening 1505 has been filled with a conductive fill material 1530, which may have the same or a different material composition than the conductive cap 1521. In some examples, the conductive fill material 1530 may be tungsten, ruthenium, molybdenum, or another suitable conductive material. In some examples, an additional liner may be deposited over the conductive cap 1521 (and over a liner of the conductive cap material, if present). In one such example, an additional liner may act as an adhesion layer to improve adhesion of the conductive fill material on the bottom and sidewalls of the opening 1505. Examples of liner and conductive fill materials include: TiN, WCN, or MoCN as a liner with tungsten as a fill material, tantalum or TiN as a liner with ruthenium as a fill material, and tungsten as a fill material without an additional liner. Other examples of liners and conductive fill materials are also possible. In an example in which the conductive fill material 1530 and the conductive cap 1521 have the same material composition (e.g., where both the conductive fill material 1530 and the conductive cap 1521 include ruthenium), there may be differences in the conductive fill material 1530 and the conductive cap 1521 resulting from different processes used to deposit the materials. For example, if the conductive fill material 1530 is deposited using a PVD process and the conductive cap 1521 is deposited using a selective ALD or selective CVD process, the conductive fill material 1530 may have a higher purity relative to the conductive cap 1521, which may include impurities such as carbon. In another example in which the conductive fill material 1530 and the conductive cap 1521 have the same material composition, the conductive fill material 1530 may have a larger grain size than the conductive cap 1521. In other examples, the conductive fill material 1530 may have a different material composition than the conductive cap 1521 (e.g., the conductive fill material 1530 may be tungsten and the conductive cap 1521 may include ruthenium, etc.).

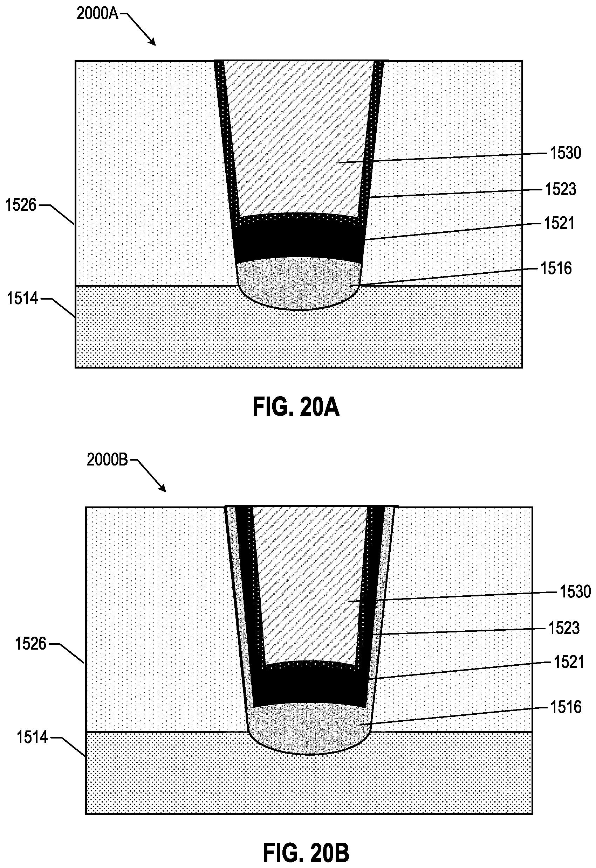

FIGS. 20A and 20B illustrate IC structures 2000A, 2000B resulting from a method 1400, and further including a process of depositing a thin liner 1523 after selectively depositing the conductive cap 1521. Thus, FIGS. 20A and 20B illustrate examples of IC structures in which a selective conductive cap 1521 is deposited at a bottom of the contact opening, followed by deposition of a very thin liner 1523 on the sidewalls of the opening and over the conductive cap 1521. The liner 1523 may be deposited with any suitable deposition technique, such as ALD, CVD, MOCVD, electroless plating, or other suitable deposition technique. FIG. 20A illustrates an example in which the interface material 1516 is limited to a bottom of the contact opening, and FIG. 20B illustrates an example in which the interface material 1516 is at the bottom and on sidewalls of the contact opening. In one example, the liner 1523 has a thickness (e.g., the thickness of the liner 1523 on the sidewalls and/or the thickness of the liner 1523 at the bottom of the opening 1505) that is smaller than the thickness of the thickness of the conductive cap 1521 on the bottom of the opening 1505. In some examples, the thickness of the liner 1523 may be in a range of about 0.5 to 3 nanometers, or about 1 to 2 nanometers. In one example, the liner 1523 may have the same or a different material composition than the selectively deposited conductive cap 1521. In one example, the conductive cap 1521 includes one or more of ruthenium, molybdenum, tungsten, rhodium, iridium, rhenium, or niobium, and the liner 1523 includes one or more of ruthenium, molybdenum, tungsten, rhodium, iridium, rhenium, or niobium. The liner 1523 may be deposited with any suitable deposition technique, and may be conformal or nonconformal (e.g., having a greater thickness at the bottom over the conductive cap 1521 than on the sidewalls of the opening 1505). The liner 1523 in addition to the conductive cap 1521 may provide additional protection to the bottom contact metal (e.g., the interface material 1516) from process damage and oxidation from further processing, and may also provide protection to the sidewalls from metallization process byproducts.

Thus, FIGS. 7 and 14 illustrate example methods 700 and 1400 including selective cap and liner deposition techniques. Performing the methods 700 and 1400 may result in several features in the final IC structures that are characteristic of the use of the methods 700 and 1400. For example, one such feature indicative of performance of the method 700 of FIG. 7 is illustrated in an IC structure 1300 shown in FIG. 13 in which metal lines in a BEOL layer are lined with a ruthenium-based material and capped with a ruthenium (or other) conductive cap. In another example, one such feature indicative of performance of the method 1400 of FIG. 14 is illustrated in the IC structures 1900A-1900D and 2000A-2000B, in which a conductive cap is present between the silicide and the conductive fill material of the contact structure. In some examples, the conductive cap is a hermetic cap. In the contact structure, the liner and/or selectively deposited cap may provide protection to the metal-silicon contact and/or surrounding insulator material without taking up excessive space in the contact structure. In the conductive interconnect, the liner and/or selectively deposited cap may limit electromigration without requiring an excessively thick cap.

IC devices/structures fabricated using selective conductive cap and liner deposition techniques as described herein (e.g., as described with reference to FIGS. 1-20B) may be used to implement any suitable components. For example, in various embodiments, IC devices described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC devices disclosed herein, e.g., the IC structures 200, 300, 400, 500, 600, 1900A-1900D, 2000A, 2000B, or any variations thereof, may be included in any suitable electronic component. FIGS. 21-24 illustrate various examples of apparatuses that may include any of the IC devices disclosed herein.

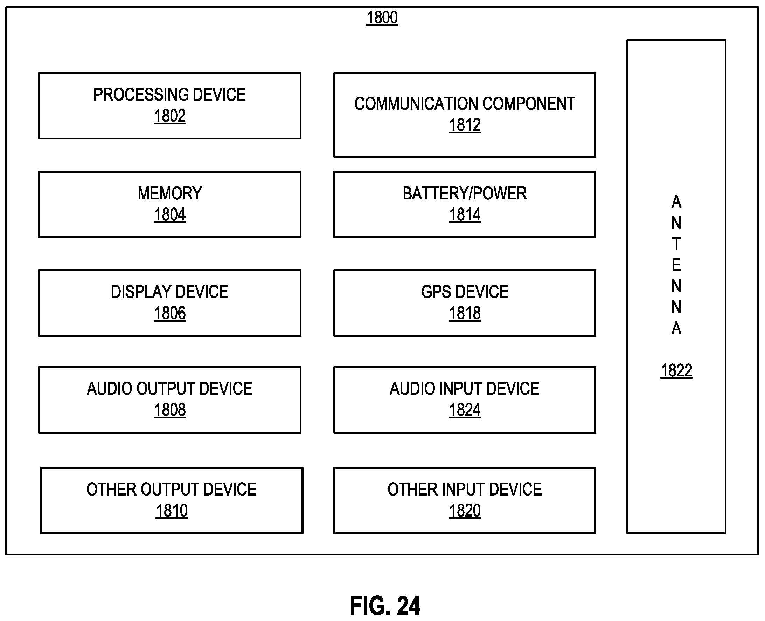

FIG. 21 is a top view of a wafer 1501 and dies 1502 that may include one or more IC structures in accordance with any of the embodiments disclosed herein. The wafer 1501 may be composed of semiconductor material and may include one or more dies 1502 having IC structures formed on a surface of the wafer 1501. Each of the dies 1502 may be a repeating unit of a semiconductor product that includes any suitable IC. After the fabrication of the semiconductor product is complete, the wafer 1501 may undergo a singulation process in which the dies 1502 are separated from one another to provide discrete "chips" of the semiconductor product. The die 1502 may include one or more IC structures as described herein (e.g., any of the IC structures 200, 300, 400, 500, 600, 1900A-1900D, 2000A, 2000B, described herein), one or more transistors (e.g., nanoribbon transistors of the IC structures 200, 300, 400, 500, 600, 1900A-1900D, 2000A, 2000B) and/or supporting circuitry to route electrical signals to the transistors, as well as any other IC components. In some embodiments, the wafer 1501 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 24) or other logic that is configured to store information in the memory devices or execute instructions stored in the memory array.

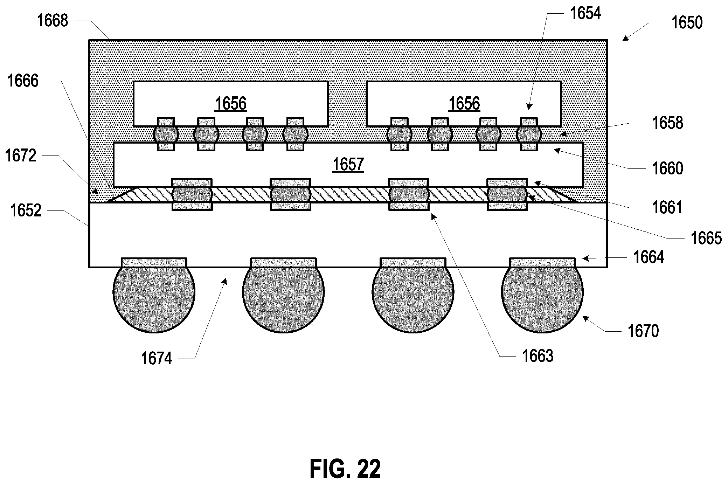

FIG. 22 is a side, cross-sectional view of an example IC package 1650 that may include one or more IC structures in accordance with any of the embodiments disclosed herein (e.g., any of the IC structures 200, 300, 400, 500, 600, 1900A-1900D, 2000A, 2000B, described herein). In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 22 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 22 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

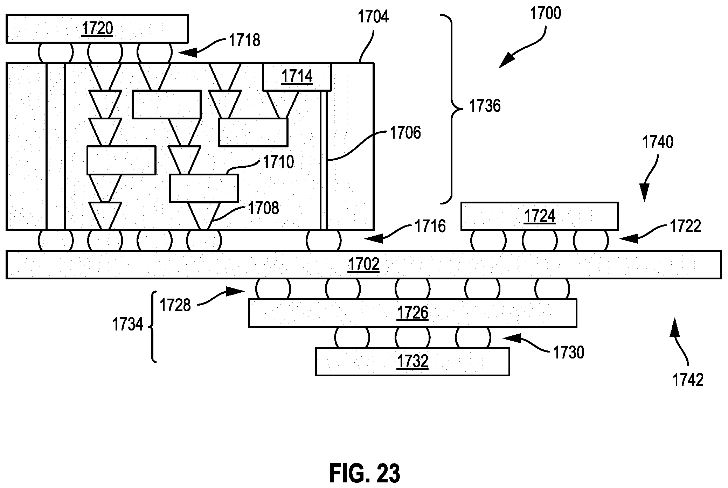

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 22 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 23.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 22 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 22, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 23 is a side, cross-sectional view of an IC device assembly 1700 that may include one or more IC packages or other electronic components (e.g., a die) including one or more IC devices in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 22 (e.g., may include one or more IC structures 200, 300, 400, 500, 600, 1900A-1900D, 2000A, 2000B).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 23 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 23), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 23, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 21), an IC device (e.g., any of the IC structures 200, 300, 400, 500, 600, 1900A-1900D, 2000A, 2000B, described herein, or any combination of such IC structures), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 23, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 23 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 24 is a block diagram of an example electrical device 1800 that may include one or more IC structures 100 in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 24 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 24, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a device region; and an interconnect layer over the device region, where the interconnect layer includes an insulator material, a conductive interconnect in an opening in the insulator material, where the conductive interconnect includes a first conductive material (e.g., copper or other conductive material) and has a length that is substantially parallel to the device region, a liner on sidewalls of the opening, where the liner includes ruthenium, and a second conductive material (e.g., a conductive cap material) over the first conductive material and over the liner, where the second conductive material includes ruthenium.

Example 2 provides the IC structure of example 1, where: the liner has a first thickness, where the first thickness is a dimension of the liner in a first plane substantially parallel to the device region; and the second conductive material has a second thickness in a range of about one to two times the first thickness, where the second thickness is a dimension of the second conductive material in a second plane substantially orthogonal to the first plane.

Example 3 provides the IC structure of any one of examples 1-2, where: the liner further includes one or more of: tantalum, nitrogen, and cobalt.

Example 4 provides the IC structure of any one of examples 1-3, where: the liner is a multi-layered liner that includes a first layer and a second layer, where the first layer includes tantalum and the second layer includes ruthenium.

Example 5 provides the IC structure of example 4, where: the first layer is between the insulator material and the second layer; and the second layer is between the first layer and the first conductive material.

Example 6 provides the IC structure of any one of examples 1-3, where: the liner that includes ruthenium is in contact with the insulator material at the sidewalls of the opening and in contact with the first conductive material.

Example 7 provides the IC structure of any one of examples 1-6, where: the second conductive material includes an alloy including ruthenium and one or more of cobalt, molybdenum, tungsten, rhodium, iridium, rhenium, and niobium.

Example 8 provides the IC structure of any one of examples 1-7, where: the liner has a thickness in a range of about 0.5-2 nanometers; and the second insulator material has a thickness in a range of about 0.5-4 nanometers.

Example 9 provides an IC structure, including FEOL layer; and a BEOL layer over the FEOL layer, where the BEOL layer includes an insulator material, a conductive line in an opening in the insulator material, where the conductive line includes a first conductive material, a liner on sidewalls of the opening, where the liner includes ruthenium and has a first thickness, where the first thickness is a dimension of the liner in a first plane substantially parallel to the FEOL layer, and a second conductive material over the first conductive material and over the liner, where: the second conductive material has a second thickness, the second thickness is a dimension of the second conductive material in a second plane that is substantially orthogonal to the first plane, and a ratio of the second thickness to the first thickness is in a range of about 1 to 2.

Example 10 provides the IC device of example 9, where: liner includes TaN, RuCo, TaNRu, RuTaN, or TaNRuTaNCo.

Example 11 provides the IC device of any one of examples 9-10, where: the second conductive material includes one or more of: ruthenium, molybdenum, tungsten, rhodium, iridium, rhenium, and niobium.

Example 12 provides the IC device of example 11, where: the second conductive material further includes cobalt.

Example 13 provides the IC structure of any one of examples 9-12, where: the liner is a multi-layered liner that includes a first liner material and a second liner material, where the first liner material includes tantalum and the second liner material includes ruthenium.

Example **14** provides the IC structure of example 13, where: the first liner material (e.g., tantalum) is between the insulator material and the second liner material; and the second liner material (e.g., the ruthenium-based material) is between the first liner material and the first conductive material (e.g., copper).

Example 15 provides the IC structure of any one of examples 9-12, where: the liner that includes ruthenium includes a continuous portion in contact with and between the insulator material and the first conductive material.

Example 16 provides the IC structure of any one of examples 1-15, where: the first thickness is in a range of about 0.5-2 nanometers; and the second thickness is in a range of about 0.5-4 nanometers.

Example 17 provides a method of fabricating an IC structure, the method including providing a preliminary IC structure including a device region and a layer over the device region that includes an insulator material; forming an opening in the insulator material; providing a liner on sidewalls and a bottom of the opening, where the liner includes ruthenium; filling the lined opening with a first conductive material (e.g., copper); and providing a second conductive material over the first conductive material and over the liner on the sidewalls of the opening, where the second conductive material includes ruthenium, molybdenum, tungsten, rhodium, iridium, rhenium, or niobium.

Example 18 provides the method of example 17, where: providing the liner includes providing the liner on the sidewalls having a first thickness, where the first thickness is a dimension of the liner on the sidewalls in a first plane substantially parallel to the device region; providing the second conductive material includes providing the second conductive material having a second thickness, where the second thickness is a dimension of the second conductive material in a second plane substantially orthogonal to the first plane; and the ratio of the second thickness to the first thickness is in a range of about 1 to 2.

Example 19 provides the method of any one of examples 17-18, where: providing the second conductive material includes selectively depositing the second conductive material on the first conductive material and on exposed portions of the liner.

Example 20 provides the method of any one of examples 17-19, where: the second conductive material is an alloy including one or more of: cobalt, ruthenium, molybdenum, tungsten, rhodium, iridium, rhenium, or niobium.

Example 21 provides an IC structure, including a region of a doped semiconductor material, where the region is either a source region or a drain region of a transistor; and a contact structure coupled with the region, where the contact structure includes a first conductive material (e.g., a conductive fill material) in an opening in an insulator material, an interface material (e.g., TiSi or other interface material) between the region and the first conductive material, and a second conductive material (e.g., a conductive cap material) including ruthenium between the interface material and the first conductive material, where: the second conductive material has a first thickness at a bottom of the opening, and a thickness of the second conductive material on sidewalls of the opening is at most 15% of the first thickness.

Example 22 provides the IC structure of example 21, where: the second conductive material is substantially absent from the sidewalls of the opening.

Example 23 provides the IC structure of example 21, further including a layer of the second conductive material on the sidewalls of the opening, where: the layer has the thickness, and a ratio of the first thickness to the thickness is in a range of about 7:1 and 10:1.

Example 24 provides the IC structure of any one of examples 21-23, where: the first thickness is a dimension of the second conductive material at a bottom of the opening in a plane substantially orthogonal to a substrate over which the region is disposed, and the first thickness is in a range of about 4-10 nanometers.

Example 25 provides the IC structure of any one of examples 21-24, further including a liner between the insulator material and the first conductive material, where the liner includes a metal and has a different material composition than the first conductive material and the second conductive material.

Example 26 provides the IC structure of example 25, where: the second conductive material is present on the sidewalls of the opening; and the liner is between the second conductive material and the first conductive material.

Example 27 provides the IC structure of any one of examples 21-26, where: the second conductive material further includes one or more of: molybdenum, tungsten, rhodium, iridium, rhenium, niobium, and cobalt.

Example 28 provides the IC structure of any one of examples 21-27, where: the interface material is present on sidewalls of the opening; and the second conductive material is present on the sidewalls of the opening between the interface material and the first conductive material.

Example 29 provides the IC structure of example 28, where: the interface material at the bottom of the opening has a first thickness; the interface material on the sidewalls of the opening has a second thickness; and a ratio of the first thickness to the second thickness is in a range of 3.5:1 to 10:1.

Example 30 provides an IC structure, including a first layer including a region of a doped semiconductor material, where the region is a source region or a drain region of a transistor; a second layer including a conductive interconnect; and a contact structure between and coupled with the region and the conductive interconnect, where the contact structure includes a fill material, an interface material between the region and the fill material, where the interface material includes a silicide, and a conductive material (e.g., a conductive cap material) between the interface material and the fill material, where the conductive material include ruthenium.

Example 31 provides the IC structure of example 30, where: the conductive material of the contact structure is substantially limited to an area between the fill material and the interface material.

Example 32 provides the IC structure of examples 30 or 31, where: the contact structure is in an opening in an insulator material; and the conductive material is substantially absent on sidewalls of the opening.

Example 33 provides the IC structure of any one of examples 30-32, where: the contact structure is in an opening in an insulator material; the IC structure further includes a liner of the conductive material on sidewalls of the opening; the conductive material has a first thickness between the interface material and the fill material and a second thickness on the sidewalls of the opening; and a ratio of the first thickness to the second thickness is in a range of about 7:1 and 10:1.

Example 34 provides the IC structure of example 33, where: a thickness of the conductive material between the interface material and the fill material is in a range of about 4-10 nanometers.

Example 35 provides the IC structure of any one of examples 33-34, where the liner is a first liner and where the IC structure further includes a second liner on the sidewalls of the opening between the first liner and the fill material, where the second liner includes a metal and has a different material composition than the first liner.

Example 36 provides the IC structure of any one of examples 30-35, where: the conductive material further includes one or more of: molybdenum, tungsten, rhodium, iridium, rhenium, niobium, and cobalt.

Example 37 provides the IC structure of any one of examples 30-36, where: the contact structure is in an opening in an insulator material; and the IC structure further includes a liner of the conductive material on sidewalls of the opening, and a layer of the interface material on the sidewalls of the opening between the insulator material and the liner.

Example 38 provides the IC structure of example 37, where: the interface material at the bottom of the opening has a first thickness; the interface material on the sidewalls of the opening has a second thickness; and the first thickness is greater than the second thickness.

Example 39 provides a method of fabricating an IC structure, the method including providing a preliminary IC structure including: a first layer including a region of a doped semiconductor material that is a source or drain region of a transistor, and a second layer over the first layer, where the second layer includes an insulator material; forming an opening in the insulator material, where the doped semiconductor material is exposed in the opening; providing an interface material (e.g., depositing titanium to form TiSi, or other technique to form an interface material) over the exposed semiconductor material at a bottom of the opening; providing a first conductive material over the interface material at a bottom of the opening, where the first conductive material includes ruthenium; and filling the opening with a second conductive material over the first conductive material.

Example 40 provides the method of example 39, where: providing the first conductive material includes selectively depositing the first conductive material over the interface material without substantially depositing the first conductive material on sidewalls of the opening.

Example 41 provides the method of example 39 or 40, where: providing the first conductive material includes depositing the first conductive material with a first thickness at the bottom of the opening, and depositing the first conductive material with a second thickness on sidewalls of the opening, where a ratio of the first thickness to the second thickness is in a range of about 7:1 to 10:1.

Example 42 provides the method of any one of examples 39-41, where: the first conductive material has a thickness at the bottom of the opening in a range of about 4-10 nanometers, where the thickness is a dimension of the first conductive material in a plane substantially orthogonal to a substrate over which the first layer is disposed.

Example 43 provides the method of any one of examples 39-42, where: providing the first conductive material over the interface material at the bottom of the opening includes selectively depositing the first conductive material at the bottom of the opening; and after selectively depositing the first conductive material at the bottom of the opening, the method further includes depositing a liner on sidewalls of the opening and over the first conductive material at the bottom of the opening.

Example 44 provides the method of example 43, where: the liner includes ruthenium.

Example 45 provides the method of any one of examples 39-44, where: the first conductive material further includes one or more of: molybdenum, tungsten, rhodium, iridium, rhenium, niobium, and cobalt.

Example 46 provides the method of any one of examples 39-45, further including providing the interface material on sidewalls of the opening; and providing the first conductive material over the interface materials on the sidewalls of the opening.

Example 47 provides the method of example 46, where: the interface material at the bottom of the opening has a first thickness; the interface material on the sidewalls of the opening has a second thickness; and a ratio of the first thickness to the second thickness is in a range of 3.5:1 to 10:1.

Example 48 provides the method of any one of examples 39-47, further including providing a liner (e.g., a metal nitride such as TiN, WCN, MoCN or a metal such as tantalum) on sidewalls of the opening and over the first conductive material at the bottom of the opening prior to filling the opening with the second conductive material, where the liner includes a third conductive material having a different material composition than the first conductive material and the second conductive material.

Example 49 provides the method of example 48, where: the first conductive material is present on the sidewalls of the opening; and providing the liner includes providing the liner over the first conductive material on the sidewalls of the opening.

Example 50 provides the method of any one of examples 39-49, further including performing a pre-clean process on exposed portions of the semiconductor material prior to providing the interface material.

Example 51 provides the method of any one of examples 39-50, where: the second conductive material (e.g., the fill material) includes tungsten or ruthenium.

Example 52 provides an IC structure according to any one of examples 1-16 and 21-38, where the IC structure includes or is a part of a central processing unit.

Example 53 provides an IC structure according to any one of examples 1-16, 21-38, and 52 where the IC structure includes or is a part of a memory device.

Example 54 provides an IC structure according to any one of examples 1-16, 21-38, and 52-53, where the IC structure includes or is a part of a logic circuit.

Example 55 provides an IC structure according to any one of examples 1-16, 21-38, and 52-54, where the IC structure includes or is a part of input/output circuitry.

Example 56 provides an IC structure according to any one of examples 1-16, 21-38, and 52-55, where the IC structure includes or is a part of a field programmable gate array transceiver.

Example 57 provides an IC structure according to any one of examples 1-16, 21-38, and 52-56, where the IC structure includes or is a part of a field programmable gate array logic.

Example 58 provides an IC structure according to any one of examples 1-16, 21-38, and 52-57, where the IC structure includes or is a part of a power delivery circuitry.

Example 59 provides an IC package that includes an IC die including an IC structure according to any one of examples 1-16, 21-38, and 52-58; and a further IC component, coupled to the IC die.

Example 60 provides an IC package according to example 59 where the further IC component includes a package substrate.

Example 61 provides an IC package according to example 59, where the further IC component includes an interposer.

Example 62 provides an IC package according to example 59, where the further IC component includes a further IC die.

Example 63 provides a computing device that includes a carrier substrate and an IC structure coupled to the carrier substrate, where the IC structure is an IC structure according to any one of examples 1-16, 21-38, and 52-58, or the IC structure is included in the IC package according to any one of examples 59-62.

Example 64 provides a computing device according to example 63, where the computing device is a wearable or handheld computing device.

Example 65 provides a computing device according to examples 63 or 64, where the computing device further includes one or more communication chips.

Example 66 provides a computing device according to any one of examples 63-65, where the computing device further includes an antenna.

Example 67 provides a computing device according to any one of examples 63-66, where the carrier substrate is a motherboard.

Example 68 provides a method according to any one of examples 17-20 and 39-51, where the IC structure is an IC structure according to any one of the preceding examples.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a region of a doped semiconductor material, wherein the region is either a source region or a drain region of a transistor; and
a contact structure coupled with the region, wherein the contact structure includes:
a first conductive material in an opening in an insulator material,
an interface material between the region and the first conductive material, and
a second conductive material including ruthenium between the interface material and the first conductive material, wherein:
the second conductive material has a first thickness at a bottom of the opening, and
a thickness of the second conductive material on sidewalls of the opening is at most 15% of the first thickness.

2. The IC structure of claim 1, wherein:
the second conductive material is substantially absent from the sidewalls of the opening.

3. The IC structure of claim 1, further comprising:
a layer of the second conductive material on the sidewalls of the opening, wherein:
the layer has the thickness, and
a ratio of the first thickness to the thickness is in a range of about 7:1 and 10:1.

4. The IC structure of any one of claims 1-3, wherein:
the first thickness is a dimension of the second conductive material at the bottom of the opening in a plane substantially orthogonal to a substrate over which the region is disposed, and
the first thickness is in a range of about 4-10 nanometers.

5. The IC structure of any one of claims 1-4, further comprising:
a liner between the insulator material and the first conductive material, wherein the liner includes a metal and has a different material composition than the first conductive material and the second conductive material.

6. The IC structure of claim 5, wherein:
the second conductive material is present on the sidewalls of the opening; and
the liner is between the second conductive material and the first conductive material.

7. The IC structure of any one of claims 1-6, wherein:
the second conductive material further includes one or more of: molybdenum, tungsten, rhodium, iridium, rhenium, niobium, and cobalt.

8. The IC structure of any one of claims 1-7, wherein:
the interface material is present on the sidewalls of the opening; and
the second conductive material is present on the sidewalls of the opening between the interface material and the first conductive material.

9. The IC structure of claim 8, wherein:
the interface material at the bottom of the opening has a third thickness;
the interface material on the sidewalls of the opening has a fourth thickness; and
a ratio of the third thickness to the fourth thickness is in a range of about 3.5:1 to 10:1.

10. A method of fabricating an integrated circuit (IC) structure, the method comprising:
providing a preliminary IC structure including:
a first layer including a region of a doped semiconductor material that is a source or drain region of a transistor, and a
second layer over the first layer, wherein the second layer includes an insulator material;
forming an opening in the insulator material, wherein the doped semiconductor material is exposed in the opening;
providing an interface material over the exposed semiconductor material at a bottom of the opening;
providing a first conductive material over the interface material at the bottom of the opening, wherein the first conductive material includes ruthenium; and
filling the opening with a second conductive material over the first conductive material.

11. The method of claim 10, wherein:
providing the first conductive material includes:
selectively depositing the first conductive material over the interface material without substantially depositing the first conductive material on sidewalls of the opening.

12. The method of claim 10 or 11, wherein:
providing the first conductive material includes:
depositing the first conductive material with a first thickness at the bottom of the opening, and
depositing the first conductive material with a second thickness on sidewalls of the opening, wherein a ratio of the first thickness to the second thickness is in a range of about 7:1 to 10:1.

13. The method of any one of claims 10-12, wherein:
the first conductive material has a thickness at the bottom of the opening in a range of about 4-10 nanometers, wherein the thickness is a dimension of the first conductive material in a plane substantially orthogonal to a substrate over which the first layer is disposed.

14. The method of any one of claims 10-13, wherein:
providing the first conductive material over the interface material at the bottom of the opening includes selectively depositing the first conductive material at the bottom of the opening; and
after selectively depositing the first conductive material at the bottom of the opening, the method further comprises depositing a liner on sidewalls of the opening and over the first conductive material at the bottom of the opening.

15. The method of claim 14, wherein:
the liner includes ruthenium, and
the first conductive material further includes one or more of: molybdenum, tungsten, rhodium, iridium, rhenium, niobium, and cobalt.
